# EUROPEAN PATENT APPLICATION

(11) **EP 4 693 399 A1**
(43) Date of publication of application: **11.02.2026**
(21) Application number: 25168757.0
(22) Date of filing: 07.04.2025
(51) Int. Cl.: H01L 23/538, H01L 25/00

(54) **SEMICONDUCTOR PACKAGE AND METHOD OF FABRICATING THE SAME**

(30) Priority: 06.08.2024 KR 20240104371
(71) Applicant: Samsung Electronics Co., Ltd., Suwon-si, Gyeonggi-do 16677 (KR)
(72) Inventor: MUN, Kyung Don, Suwon-si, Gyeonggi-do 16677 (KR); KIM, Ji Hwang, Suwon-si, Gyeonggi-do 16677 (KR); BAEK, Sangjin, Suwon-si, Gyeonggi-do 16677 (KR)
(74) Representative: Kuhnen & Wacker Patent- und Rechtsanwaltsbüro PartG mbB

(57) **Abstract**

A semiconductor package may include a first redistribution substrate, a first semiconductor chip and a second semiconductor chip, which are mounted on the first redistribution substrate and are horizontally spaced apart from each other, a first mold layer provided to surround the first and second semiconductor chips and expose bottom surfaces of the first and second semiconductor chips, a bridge chip mounted on the bottom surfaces of the first and second semiconductor chips, a second mold layer provided on the first redistribution substrate to embed the first and second semiconductor chips, the first mold layer, and the bridge chip, a second redistribution substrate disposed on the second mold layer, an upper package mounted on the second redistribution substrate, and a vertical connection structure provided adjacent to the first mold layer to connect the first and second redistribution substrates to each other. The first redistribution substrate may have a recess provided in a top surface of the first redistribution substrate, and the bridge chip may be disposed in the recess.

## Description

### CROSS-REFERENCE TO RELATED APPLICATIONS

This U.S. non-provisional patent application claims priority under 35 U.S.C. §119 to Korean Patent Application No. 10-2024-0104371, filed on August 6, 2024, in the Korean Intellectual Property Office, the entire contents of which are hereby incorporated by reference.

### BACKGROUND OF THE INVENTION

The present disclosure relates to a semiconductor package and a method of fabricating the same, and in particular, to a semiconductor package including a bridge chip and a method of fabricating the same.

With the recent advance in the electronics industry, the demand for high-performance, high-speed, and compact electronic components is increasing. To meet this demand, packaging technologies of mounting a plurality of semiconductor chips in a single package are being developed.

A semiconductor package is configured to facilitate the use of an integrated circuit chip as a component in an electronic product. In general, the semiconductor package includes a printed circuit board (PCB) and a semiconductor chip, which is mounted on the PCB and is electrically connected to the PCB by bonding wires or bumps. Recently, various studies have been conducted to reduce the size and weight of semiconductor packages and their fabrication costs. Furthermore, as the utilization of this technology expands to different fields, including mass storage devices, several types of semiconductor packages have emerged.

As the integration density of semiconductor chips increases, their size gradually decreases. However, in the case where the size of the semiconductor chip is reduced, it is increasingly difficult to attach many solder balls to the semiconductor chip and to handle and test the solder balls. In addition, it is often necessary to diversify a board in accordance with a size of a semiconductor chip, and this is another difficult problem. In order to address these issues, fan-out panel-type packages have been proposed.

### SUMMARY

Aspects of the inventive concept provides a semiconductor package configured to have a small size.

Aspects of the inventive concept provides a semiconductor package with improved electrical and heat-dissipation characteristics.

Aspects of the inventive concept provides a method of simplifying a process of fabricating a semiconductor package.

According to an embodiment of the inventive concept, a semiconductor package may include a first redistribution substrate, a first semiconductor chip and a second semiconductor chip, which are mounted on the first redistribution substrate and are horizontally spaced apart from each other, a first mold layer provided to surround the first and second semiconductor chips and expose bottom surfaces of the first and second semiconductor chips, a bridge chip mounted on the bottom surfaces of the first and second semiconductor chips, a second mold layer provided on the first redistribution substrate to embed the first and second semiconductor chips, the first mold layer, and the bridge chip, a second redistribution substrate disposed on the second mold layer, an upper package mounted on the second redistribution substrate, and a vertical connection structure provided adjacent to the first mold layer to connect the first and second redistribution substrates to each other. The first redistribution substrate may have a recess provided in a top surface of the first redistribution substrate, and the bridge chip may be disposed in the recess.

According to an embodiment of the inventive concept, a semiconductor package may include a lower package and an upper package mounted on the lower package. The lower package may include a first redistribution substrate, a module structure mounted on the first redistribution substrate, an outer mold layer provided on the first redistribution substrate to cover the module structure, and a vertical connection structure, which is horizontally spaced apart from the module structure, is provided to vertically penetrate the outer mold layer, and is connected to the first redistribution substrate. The module structure may include a first logic chip and a second logic chip, which are horizontally spaced apart from each other, an inner mold layer surrounding the first and second logic chips and exposing a bottom surface of the first logic chip and a bottom surface of the second logic chip, and a bridge chip mounted on the bottom surfaces of the first and second logic chips. The upper package may include an upper package substrate, a memory chip mounted on the upper package substrate, and an upper mold layer provided on the upper package substrate to cover the memory chip.

According to an embodiment of the inventive concept, a semiconductor package may include a first redistribution substrate having a recess region provided in a top surface of the first redistribution substrate, a module structure mounted on the first redistribution substrate, a first mold layer provided on the first redistribution substrate to cover the module structure, a second redistribution substrate disposed on the first mold layer, a vertical structure provided to vertically penetrate the first mold layer and connect the first and second redistribution substrates to each other, an upper package mounted on the second redistribution substrate, a heat-dissipation member attached to the second redistribution substrate and spaced apart from the upper package, and outer terminals provided on a bottom surface of the first redistribution substrate. The module structure may include a first semiconductor chip including a first chip pad provided on a bottom surface of the first semiconductor chip, a second semiconductor chip horizontally spaced apart from the first semiconductor chip, the second semiconductor chip including a second chip pad provided on a bottom surface of the second semiconductor chip, and a bridge chip provided on the bottom surfaces of the first and second semiconductor chips and mounted on the first and second chip pads. The bridge chip may be disposed in the recess region.

According to an embodiment of the inventive concept, a method of fabricating a semiconductor package may include placing a first semiconductor chip and a second semiconductor chip to be spaced apart from each other, forming a first mold layer to surround the first and second semiconductor chips, the first mold layer exposing an active surface of the first semiconductor chip and an active surface of the second semiconductor chip, mounting a bridge chip on the active surface of the first semiconductor chip and the active surface of the second semiconductor chip to form a module structure, forming a recess in a top surface of a first redistribution substrate, placing the module structure on the first redistribution substrate to insert the bridge chip in the recess, forming a vertical connection structure on the first redistribution substrate to be horizontally spaced apart from the module structure, forming a second mold layer on the first redistribution substrate to cover the module structure and the vertical connection structure, and forming a second redistribution substrate on the second mold layer.

### BRIEF DESCRIPTION OF THE DRAWINGS

FIG. 1 is a sectional view illustrating a semiconductor package according to an embodiment of the inventive concept.
FIGS. 2 and 3 are sectional views illustrating a module structure.
FIGS. 4 and 5 are sectional views illustrating a semiconductor package according to an embodiment of the inventive concept.
FIG. 6 is a sectional view illustrating a module structure.
FIGS. 7 to 15 are sectional views illustrating a semiconductor package according to an embodiment of the inventive concept.
FIGS. 16 to 28 are sectional views illustrating a method of fabricating a semiconductor package, according to an embodiment of the inventive concept.

### DETAILED DESCRIPTION

Example embodiments of the inventive concepts will now be described more fully with reference to the accompanying drawings, in which example embodiments are shown.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

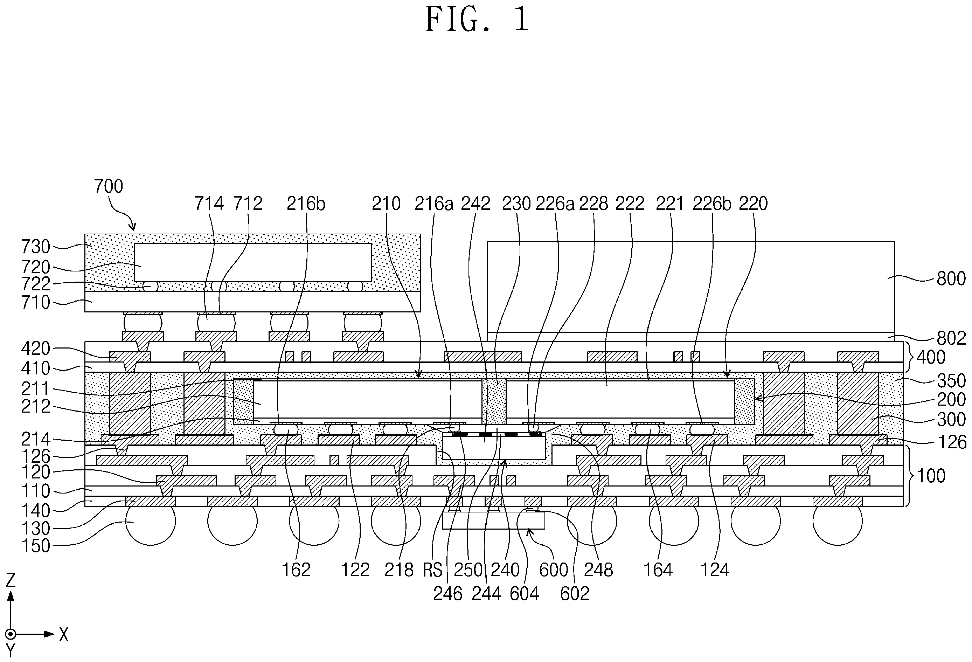

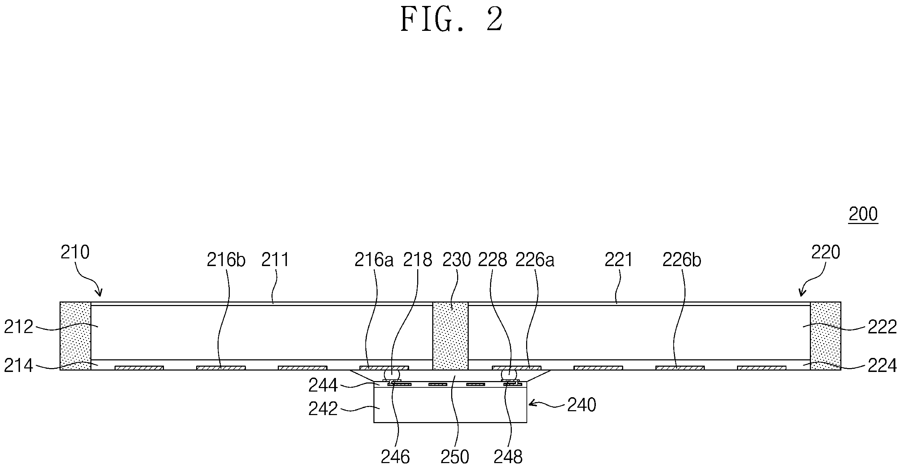

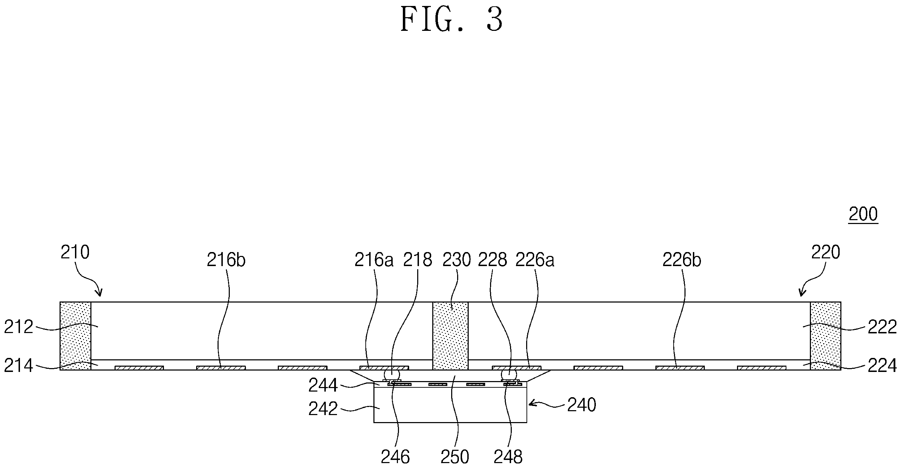

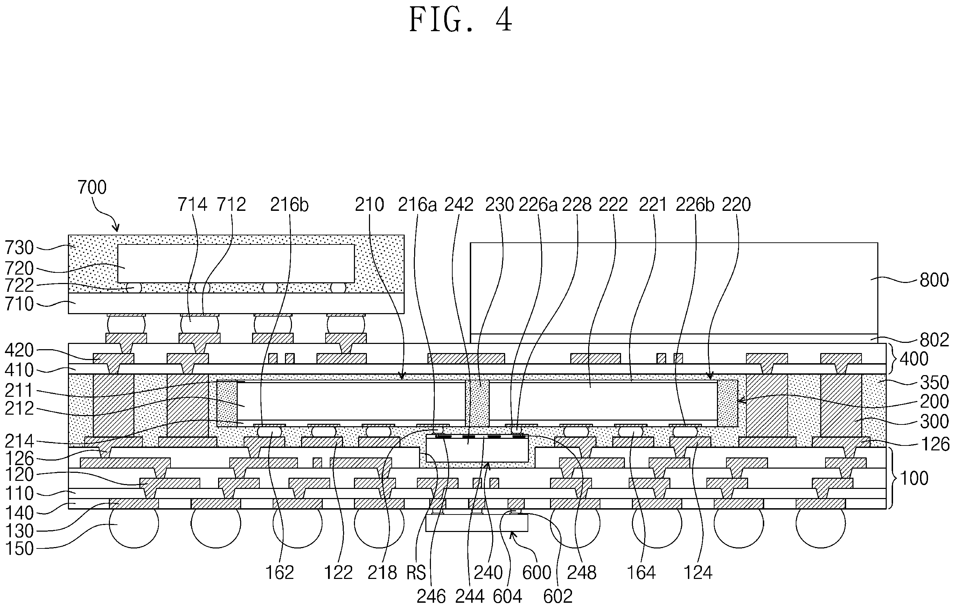

FIG. 1 is a sectional view illustrating a semiconductor package according to an embodiment of the inventive concept. FIGS. 2 and 3 are sectional views illustrating a module structure. FIG. 4 is a sectional view illustrating a semiconductor package according to an embodiment of the inventive concept. The various section views described herein may be cross-sectional views, for example, as viewed from a first horizontal direction.

Referring to FIG. 1, a lower package is provided. The lower package may include a first redistribution substrate 100, a module structure 200, conductive posts 300, a second mold layer 350, and a second redistribution substrate 400.

In one embodiment, the first redistribution substrate 100 may include one or more first substrate interconnection layers which are stacked. Each of the first substrate interconnection layers may include a first substrate insulating pattern 110 and a first substrate interconnection pattern 120 in the first substrate insulating pattern 110. The first substrate interconnection pattern 120 of one of the first substrate interconnection layers may be electrically connected to the first substrate interconnection pattern 120 of another first substrate interconnection layer adjacent thereto.

The first substrate insulating pattern 110 may include an insulating polymer or a photoimageable dielectric (PID) material. For example, the photoimageable dielectric material may include at least one of photoimageable polyimide (PI), polybenzoxazole (PBO), phenol-based polymers, or benzocyclobutene-based polymers. Alternatively, the first substrate insulating pattern 110 may include another type of insulating material. For example, the first substrate insulating pattern 110 may be formed of or include silicon oxide, silicon nitride, silicon oxynitride, or insulating polymers.

The first substrate interconnection pattern 120 may be provided on the first substrate insulating pattern 110 formed therebelow. The first substrate interconnection pattern 120 may extend horizontally on the first substrate insulating pattern 110. The first substrate interconnection pattern 120 may be provided on a top surface of the first substrate insulating pattern 110 formed therebelow. The first substrate interconnection pattern 120 may extend above the top surface of the first substrate insulating pattern 110 formed therebelow, thereby having a protruding shape. The first substrate interconnection pattern 120 on the first substrate insulating pattern 110 may be covered with another first substrate insulating pattern 110 thereon. The first substrate interconnection pattern 120, which is provided in the uppermost one of the first substrate interconnection layers, may be used as a substrate pad, to which the module structure 200 and the conductive posts 300 are coupled. For example, portions of the first substrate interconnection pattern 120, which is provided in the uppermost one of the first substrate interconnection layers, may be first substrate pads 122, which are used for mounting a first semiconductor chip 210 of the module structure 200 to be described below, other portions of the first substrate interconnection pattern 120, which is provided in the uppermost one of the first substrate interconnection layers, may be second substrate pads 124, which are used for mounting a second semiconductor chip 220 to be described below, and still other portions the first substrate interconnection pattern 120, which is provided in the uppermost one of the first substrate interconnection layers, may be third substrate pads 126, which are used for mounting the conductive posts 300. The first substrate interconnection pattern 120 may be a pad portion or an interconnection portion of the first substrate interconnection layer, as described above. For example, the first substrate interconnection pattern 120 may be used for a horizontal redistribution of the first redistribution substrate 100. The first and second substrate pads 122 and 124 may be placed on a center portion of the first redistribution substrate 100. The third substrate pads 126 may be placed on an outer portion of the first redistribution substrate 100. The first substrate interconnection pattern 120 may include a conductive material. For example, the first substrate interconnection pattern 120 may be or may include a metallic material (e.g., copper).

The first substrate interconnection pattern 120 may have a damascene structure. For example, the first substrate interconnection pattern 120 may include a via portion protruding in a downward direction from a line portion. The via portion may be configured to vertically connect the first substrate interconnection patterns 120, which are included in adjacent ones of the first substrate interconnection layers, to each other. Alternatively, the via portion may be used to connect the first substrate interconnection pattern 120 of the lowermost one of the first substrate interconnection layers to outer pads 130. For example, the via portion may extend from a bottom surface of the first substrate interconnection pattern 120 to penetrate the first substrate insulating pattern 110 and may be coupled to a top surface of the first substrate interconnection pattern 120 of another first substrate interconnection layer thereunder. Alternatively, the via portion may extend from the bottom surface of the first substrate interconnection pattern 120 to penetrate the lowermost one of the first substrate insulating patterns 110 and may be coupled to a top surface of the outer pad 130. For example, an upper portion of the first substrate interconnection pattern 120, which is placed on the first substrate insulating pattern 110, may be a head portion serving as a horizontal line or a pad, and the via portion of the first substrate interconnection pattern 120 may be a tail portion. The first substrate interconnection pattern 120 may be a 'T'-shaped pattern.

The outer pads 130 may be provided on a bottom surface of the lowermost one of the first substrate interconnection layers. The outer pads 130 may be electrically connected to the first substrate interconnection pattern 120. Outer terminals 150 may be provided on and coupled to the outer pads 130.

A substrate protection layer 140 may be provided. The substrate protection layer 140 may cover a bottom surface of the lowermost one of the first substrate interconnection layers and may expose the outer pads 130. The outer terminals 150 may be provided on the exposed bottom surfaces of the outer pads 130. The outer terminals 150 may include solder balls or solder bumps, and depending on the kind and arrangement of the outer terminals 150, the semiconductor package may have a ball grid array (BGA) structure, a fine-ball grid array (FBGA) structure, or a land grid array (LGA) structure.

The first redistribution substrate 100 may be provided to have the afore-described structure. However, the inventive concept is not limited to this example. The first redistribution substrate 100 may be a PCB. For example, the first redistribution substrate 100 may include a core layer and peripheral portions, which are provided on and under the core layer and are used for interconnection.

The first redistribution substrate 100 may have a recess region RS. The recess region RS may be an empty region, which is formed by recessing a top surface of the first redistribution substrate 100. For example, the recess region RS may be provided to penetrate at least a portion of the uppermost first substrate interconnection layer (e.g., at least a portion of the uppermost one of the first substrate insulating patterns 110). The recess region RS may not penetrate the first redistribution substrate 100 fully in a vertical direction. For example, a depth of the recess region RS (i.e., a distance from the top surface of the first redistribution substrate 100 to a bottom surface of the recess region RS) may be less than a thickness of the first redistribution substrate 100. For example, the thickness of the first redistribution substrate 100 may be in a range from 20 µm to 50 µm. The depth of the recess region RS may be in a range from 1 µm to 10 µm. The recess region RS may be placed in the center portion of the first redistribution substrate 100. When viewed in a plan view (e.g., from a vertical, Z direction), the recess region RS may be placed between the first substrate pads 122 and the second substrate pads 124 in the horizontal, X direction. The recess region RS may be a space, or recess, in which a bridge chip 240 of the module structure 200 to be described below is inserted. In addition, though not shown in the figures, the recess RS may extend lengthwise to fully pass through the first redistribution substrate 100 in a horizontal, Y direction, or may extend only partly through the first redistribution substrate 100 in the horizontal, Y direction, to be surrounded on four sides by the first redistribution substrate 100.

The module structure 200 may be provided on the first redistribution substrate 100. The module structure 200 may be located on the center portion of the first redistribution substrate 100. The module structure 200 may be placed over the recess region RS of the first redistribution substrate 100. The module structure 200 may cover the recess region RS of the first redistribution substrate 100. The module structure 200 may include a first semiconductor chip 210, a second semiconductor chip 220, a first mold layer 230, and a bridge chip 240, and may therefore be a multi-chip structure.

Referring to FIGS. 1 and 2, the first semiconductor chip 210 may be disposed on the first redistribution substrate 100. A portion of the first semiconductor chip 210 may vertically overlap a portion of the recess region RS. Another portion of the first semiconductor chip 210 may be placed in a region that does not overlap the recess region RS, when viewed in a plan view (e.g., in the vertical direction). The first semiconductor chip 210 may include a first base layer 212 and a first chip interconnection layer 214.

The first base layer 212 may include a semiconductor substrate. For example, the first base layer 212 may be a semiconductor substrate (e.g., a semiconductor wafer). The first base layer 212 may be a silicon substrate, a silicon-on-insulator (SOI) substrate, a germanium (Ge) substrate, a germanium-on-insulator (GOI) substrate, a silicon-germanium (SiGe) substrate, a group III-V semiconductor substrate, or a substrate including an epitaxial film formed by a selective epitaxial growth (SEG) process. The first base layer 212 may be formed of or include at least one of, for example, silicon, germanium, silicon germanium, gallium arsenic, indium gallium arsenic, or aluminum gallium arsenic. A first integrated circuit may be provided on a bottom surface of the first base layer 212. The first integrated circuit may include a logic circuit. For example, the first semiconductor chip 210 may be a logic chip. In an embodiment, the first semiconductor chip 210 may include a logic chip with memory elements, a logic semiconductor chip with various integrated circuits, or a passive device chip. A bottom surface of the first semiconductor chip 210 may be an active surface, and a top surface of the first semiconductor chip 210 may be an inactive surface. The first semiconductor chip 210 may be disposed on the first redistribution substrate 100 in a face-down manner. Hereinafter, in the present specification, the front surface may be defined as a surface of a semiconductor chip, which is an active surface with integrated devices, and on which interconnection wires or pads are formed, and the rear surface may be defined as a surface that is opposite to the front surface of the semiconductor chip.

The first chip interconnection layer 214 may be disposed on the bottom surface of the first base layer 212. For example, the first chip interconnection layer 214 may include a first chip insulating pattern and a first chip interconnection pattern formed on the bottom surface of the first base layer 212.

The first chip insulating pattern may be provided on the bottom surface of the first base layer 212 to cover the first integrated circuit. The first chip insulating pattern may include an insulating material. For example, the first chip insulating pattern may be formed of or include at least one of silicon oxide, silicon nitride, silicon oxynitride, silicon carbonitride, or an insulating polymer. Alternatively, the first chip insulating pattern may include an insulating polymer or a photoimageable dielectric (PID) material. Here, the PID materials may include at least one of photoimageable polyimide (PI), polybenzoxazole (PBO), phenol-based polymers, or benzocyclobutene-based polymers.

The first chip interconnection pattern may be provided in the first chip insulating pattern. The first chip interconnection pattern may be electrically connected to the first integrated circuit on the bottom surface of the first base layer 212. The first chip interconnection pattern may include or be a conductive material. For example, the first chip interconnection pattern may include or be copper or aluminum.

The first semiconductor chip 210 may include chip pads provided on the bottom surface of the first semiconductor chip 210. The chip pads may include first chip pads 216a and second chip pads 216b. The first and second chip pads 216a and 216b may be disposed on the bottom surface of the first semiconductor chip 210 (i.e., the bottom surface of the first chip interconnection layer 214). The first and second chip pads 216a and 216b may be exposed to a region under the bottom surface of the first semiconductor chip 210. The first and second chip pads 216a and 216b may be electrically connected to the first integrated circuit on the bottom surface of the first base layer 212 through the first chip interconnection pattern in the first chip interconnection layer 214. The first chip pads 216a may be placed over the recess region RS of the first redistribution substrate 100. When viewed in a plan view, the second chip pads 216b may be disposed to be horizontally spaced apart from the recess region RS of the first redistribution substrate 100. The first chip pads 216a may be disposed to be adjacent to the second semiconductor chip 220 to be described below. In an embodiment, the first chip interconnection layer 214 may further include a circuit pattern or a protection layer.

A first adhesive layer 211 may be provided on the top surface of the first semiconductor chip 210. In more detail, the first adhesive layer 211 may cover a top surface of the first base layer 212. In an embodiment, the first adhesive layer 211 may include an adhesive tape. Alternatively, the first adhesive layer 211 may include a thermal interface material (TIM) (e.g., thermal grease).

The second semiconductor chip 220 may be disposed to be horizontally spaced apart from the first semiconductor chip 210. A portion of the second semiconductor chip 220 may vertically overlap a portion of the recess region RS. Another portion of the second semiconductor chip 220 may be placed in a region that does not overlap the recess region RS, when viewed in a plan view. The recess region RS may vertically overlap a portion of the first semiconductor chip 210 and a portion of the second semiconductor chip 220. The second semiconductor chip 220 may include a second base layer 222 and a second chip interconnection layer 224.

The second base layer 222 may include a semiconductor substrate. For example, the second base layer 222 may be a semiconductor substrate (e.g., a semiconductor wafer). The second base layer 222 may be a silicon substrate, a silicon-on-insulator (SOI) substrate, a germanium (Ge) substrate, a germanium-on-insulator (GOI) substrate, a silicon-germanium (SiGe) substrate, a group III-V semiconductor substrate, or a substrate including an epitaxial film formed by a selective epitaxial growth (SEG) process. The second base layer 222 may be formed of or include at least one of, for example, silicon, germanium, silicon germanium, gallium arsenic, indium gallium arsenic, or aluminum gallium arsenic. A second integrated circuit may be provided on a bottom surface of the second base layer 222. The second integrated circuit may include a logic circuit. For example, the second semiconductor chip 220 may be a logic chip. The first and second semiconductor chips 210 and 220 may be chiplets constituting the logic circuit in the semiconductor package. For example, the first and second semiconductor chips 210 and 220 may be one of chiplets (e.g., CPU devices, GPU devices, DSI devices, CSI devices, modem devices, or PMIC devices). In an embodiment, the second semiconductor chip 220 may include or be a logic chip, a logic chip with memory elements, a logic semiconductor chip with various integrated circuits, or a passive device chip. A bottom surface of the second semiconductor chip 220 may be an active surface, and a top surface of the second semiconductor chip 220 may be an inactive surface. The second semiconductor chip 220 may be disposed on the first redistribution substrate 100 in a face-down manner.

The second chip interconnection layer 224 may be disposed on the bottom surface of the second base layer 222. For example, the second chip interconnection layer 224 may include a second chip insulating pattern and a second chip interconnection pattern, which are formed on the bottom surface of the second base layer 222.

The second chip insulating pattern may be provided on the bottom surface of the first base layer 212 to cover the second integrated circuit. The second chip insulating pattern may include an insulating material. For example, the second chip insulating pattern may be formed of or include at least one of silicon oxide, silicon nitride, silicon oxynitride, silicon carbonitride, or an insulating polymer. Alternatively, the second chip insulating pattern may include an insulating polymer or a photoimageable dielectric (PID) material. Here, the PID materials may include at least one of photoimageable polyimide (PI), polybenzoxazole (PBO), phenol-based polymers, or benzocyclobutene-based polymers.

The second chip interconnection pattern may be provided in the second chip insulating pattern. The second chip interconnection pattern may be electrically connected to the second integrated circuit on the bottom surface of the second base layer 222. The second chip interconnection pattern may include or be a conductive material. For example, the second chip interconnection pattern may include or be copper or aluminum.

The second semiconductor chip 220 may include chip pads provided on the bottom surface of the second semiconductor chip 220. The chip pads may include third chip pads 226a and fourth chip pads 226b. The third and fourth chip pads 226a and 226b may be disposed on the bottom surface of the second semiconductor chip 220 (i.e., the bottom surface of the second chip interconnection layer 224). The third and fourth chip pads 226a and 226b may be exposed to a region under the bottom surface of the second semiconductor chip 220. The third and fourth chip pads 226a and 226b may be electrically connected to the second integrated circuit on the bottom surface of the second base layer 222 through the second chip interconnection pattern in the second chip interconnection layer 224. The third chip pads 226a may be placed over the recess region RS of the first redistribution substrate 100. When viewed in a plan view, the fourth chip pads 226b may be disposed to be horizontally spaced apart from the recess region RS of the first redistribution substrate 100. The third chip pads 226a may be disposed to be adjacent to the second semiconductor chip 220. The second chip interconnection layer 224 may further include a circuit pattern or a protection layer, if necessary.

A second adhesive layer 221 may be provided on the top surface of the second semiconductor chip 220. In more detail, the second adhesive layer 221 may cover a top surface of the second base layer 222. The second adhesive layer 221 may include an adhesive tape. In an embodiment, the second adhesive layer 221 may include a thermal interface material (TIM) (e.g., thermal grease).

The first semiconductor chip 210 may be a semiconductor chip, which is included in the chiplets constituting the logic circuit in the semiconductor package and exhibits low heat generation characteristics, and the second semiconductor chip 220 may be a semiconductor chip, which is included in the chiplets constituting the logic circuit in the semiconductor package and exhibits high heat generation characteristics.

The first mold layer 230 may be provided to enclose the first and second semiconductor chips 210 and 220. The first mold layer 230 may be provided to expose top surfaces of the first and second semiconductor chips 210 and 220. In more detail, the first mold layer 230 may be provided to expose a top surface of the first adhesive layer 211 and a top surface of the second adhesive layer 221. The first mold layer 230 may be provided to expose the bottom surfaces of the first and second semiconductor chips 210 and 220. The first mold layer 230 may be provided to fill a space between the first and second semiconductor chips 210 and 220. For example, the first and second semiconductor chips 210 and 220 may be placed in the first mold layer 230, and the top and bottom surfaces of the first and second semiconductor chips 210 and 220 may be exposed to the outside of the first mold layer 230 near the top and bottom surfaces of the first mold layer 230. A width of the first mold layer 230 may be smaller than a width of the first redistribution substrate 100. The first mold layer 230 may include an insulating polymer material. For example, the first mold layer 230 may include an epoxy molding compound (EMC).

In another embodiment, as shown in FIG. 3, the first and second semiconductor chips 210 and 220 may not have the first and second adhesive layers 211 and 221, respectively. In this case, the first mold layer 230 may be provided to expose the top surface of the first semiconductor chip 210 and the top surface of the second semiconductor chip 220. In more detail, the first mold layer 230 may be provided to expose the top surface of the first base layer 212 and the top surface of the second base layer 222.

The bridge chip 240 may be disposed on the bottom surface of the first mold layer 230. The bridge chip 240 may have a front surface and a rear surface. The rear surface of the bridge chip 240 may face the first redistribution substrate 100. The front surface of the bridge chip 240 may face the first and second semiconductor chips 210 and 220. The bridge chip 240 may include a bridge base layer 242 and a bridge interconnection layer 244.

The bridge base layer 242 may include a semiconductor substrate. For example, the bridge base layer 242 may be a semiconductor substrate (e.g., a semiconductor wafer). The bridge base layer 242 may be a silicon substrate, a silicon-on-insulator (SOI) substrate, a germanium (Ge) substrate, a germanium-on-insulator (GOI) substrate, a silicon-germanium (SiGe) substrate, a group III-V semiconductor substrate, or a substrate including an epitaxial film formed by a selective epitaxial growth (SEG) process. In an embodiment, the bridge base layer 242 may be formed of or include at least one of silicon, germanium, silicon germanium, gallium arsenic, indium gallium arsenic, or aluminum gallium arsenic.

The bridge interconnection layer 244 may be disposed on a top surface of the bridge base layer 242 facing the first and second semiconductor chips 210 and 220. For example, the bridge interconnection layer 244 may include a bridge insulating pattern and a bridge interconnection pattern, which are formed on the top surface of the bridge base layer 242. In an embodiment, the bridge interconnection layer 244 may further include a circuit pattern or a protection layer.

The bridge insulating pattern may include an insulating material. For example, the bridge insulating pattern may be formed of or include silicon oxide, silicon nitride, silicon oxynitride, silicon carbonitride, or an insulating polymer. Alternatively, the bridge insulating pattern may include an insulating polymer or a photoimageable dielectric (PID) material. Here, the PID materials may include at least one of photoimageable polyimide (PI), polybenzoxazole (PBO), phenol-based polymers, or benzocyclobutene-based polymers.

The bridge interconnection pattern may be provided in the bridge insulating pattern. The bridge interconnection pattern may be used for an electric connection between the first and second semiconductor chips 210 and 220. The bridge interconnection pattern may include a conductive material. For example, the bridge interconnection pattern may be formed of or include copper or aluminum.

FIGS. 1 and 2 illustrate an example, in which the bridge base layer 242 is provided as a single layer, but the inventive concept is not limited to this example. The bridge base layer 242 may include a plurality of insulating layers, and the bridge interconnection pattern may include at least one interconnection pattern provided in the insulating layers.

The bridge chip 240 may include first bridge pads 246 and second bridge pads 248, which are provided on a top surface of the bridge chip 240. The first and second bridge pads 246 and 248 may be disposed on the top surface of the bridge chip 240 (i.e., the top surface of the bridge interconnection layer 244). In other words, the first and second bridge pads 246 and 248 may be extended above the top surface of the bridge chip 240, thereby having a protruding shape. However, the inventive concept is not limited to this example, and in an embodiment, the first and second bridge pads 246 and 248 may be portions of the bridge interconnection pattern, which are provided in the bridge insulating pattern. In this case, the first and second bridge pads 246 and 248 may be exposed to a region on a top surface of the bridge insulating pattern. The first bridge pads 246 and the second bridge pads 248 may be disposed on different regions of the bridge chip 240, respectively. In an embodiment, the first bridge pads 246 may be disposed adjacent to the first chip pads 216a of the first semiconductor chip 210, and the second bridge pads 248 may be disposed adjacent to the third chip pads 226a of the second semiconductor chip 220.

The first bridge pads 246 may be pads, which are electrically connected to the first semiconductor chip 210, and the second bridge pads 248 may be pads, which are connected to the second semiconductor chip 220. The first bridge pads 246 may be electrically connected to the second bridge pads 248 through the bridge interconnection layer 244. FIG. 1 illustrates only a portion of the bridge interconnection pattern, and this means that the first bridge pads 246 are not electrically disconnected from the second bridge pads 248 and there are interconnection structures, which connect the first and second bridge pads 246 and 248 to each other, in the bridge interconnection layer 244. The first bridge pads 246 may be electrically connected to the second bridge pads 248 through the bridge interconnection pattern in the bridge interconnection layer 244.

An interconnection density in the bridge chip 240 may be higher than an interconnection density in the first redistribution substrate 100. An integration density of the first and second bridge pads 246 and 248 may be higher than an integration density of the substrate pads of the first redistribution substrate 100. For example, a distance between the adjacent pads of the first bridge pads 246 and a distance between adjacent pads of the second bridge pads 248 may be smaller than a distance between adjacent substrate pads of the first substrate pads 122 and a distance between adjacent substrate pads of the second substrate pads 124. In addition, a width of each of the first bridge pads 246 and a width of each of the second bridge pads 248 may be smaller than a width of the first substrate pads 122 and a width of the second substrate pads 124. A pitch of the first bridge pads 246 and a pitch of the second bridge pads 248 may be smaller than a pitch of the substrate pads of the first redistribution substrate 100. The number of the first and second bridge pads 246 and 248 per unit area may be greater than the number of the substrate pads of the first redistribution substrate 100 per unit area.

The bridge chip 240 may be disposed on the bottom surface of the first mold layer 230. The bridge chip 240 may be mounted on the bottom surfaces of the first and second semiconductor chips 210 and 220. For example, first inner terminals 218 may be provided between the first bridge pads 246 and the first chip pads 216a. The first inner terminals 218 may connect the first bridge pads 246 to the first chip pads 216a. Second inner terminals 228 may be provided between the second bridge pads 248 and the third chip pads 226a. The second inner terminals 228 may connect the second bridge pads 248 to the third chip pads 226a.

According to an embodiment of the inventive concept, the bridge chip 240 may be used for the electric connection in a region with a high interconnection density (e.g., for the interconnection between the first and second semiconductor chips 210 and 220). Thus, it may be possible to increase an integration density of the semiconductor package.

An under-fill layer 250 may be provided between the first and second semiconductor chips 210 and 220 and the bridge chip 240. The under-fill layer 250 may be provided to fill a space between the first and second semiconductor chips 210 and 220 and the bridge chip 240 and enclose the first and second inner terminals 218 and 228. In another embodiment, as shown in FIG. 4, the under-fill layer may not be provided between the first and second semiconductor chips 210 and 220 and the bridge chip 240.

Referring back to FIG. 1, the module structure 200 may be disposed on the first redistribution substrate 100. Here, the bridge chip 240 of the module structure 200 may be inserted into the recess region RS of the first redistribution substrate 100. Therefore, the bridge chip 240 may be placed inside the recess region RS. The bridge chip 240 may be spaced apart from an inner side surface and a bottom surface of the recess region RS. The first and second semiconductor chips 210 and 220 and the first mold layer 230 may be spaced apart from the top surface of the first redistribution substrate 100.

The module structure 200 may be mounted on the first redistribution substrate 100. For example, the module structure 200 may be mounted on the first redistribution substrate 100 in a flip chip manner. In more detail, third inner terminals 162 may be provided between the first substrate pads 122 and the second chip pads 216b. The third inner terminals 162 may connect the first substrate pads 122 to the second chip pads 216b. Fourth inner terminals 164 may be provided between the second substrate pads 124 and the fourth chip pads 226b. The fourth inner terminals 164 may connect the second substrate pads 124 to the fourth chip pads 226b.

According to an embodiment of the inventive concept, since the first and second semiconductor chips 210 and 220 and the bridge chip 240 are provided as a single module structure 200, the fabrication process of the semiconductor package may be simplified. In addition, since the first and second semiconductor chips 210 and 220 are encapsulated by the first mold layer 230 and the second mold layer 350, the first and second semiconductor chips 210 and 220 may be stably protected from an external impact. In addition, since the bridge chip 240 connecting the first and second semiconductor chips 210 and 220 is inserted in the recess region RS of the first redistribution substrate 100, a total height of the first redistribution substrate 100 and the module structure 200 may be reduced. Accordingly, the semiconductor package may be provided to have a small height and a small size.

A passive device chip 600 may be disposed below the first redistribution substrate 100. The passive device chip 600 may be disposed below the center portion of the first redistribution substrate 100. The passive device chip 600 may be disposed on a bottom surface of the first redistribution substrate 100. The passive device chip 600 may be placed between the outer terminals 150. A thickness of the passive device chip 600 in the vertical direction may be smaller than a thickness of the outer terminals 150 in the vertical direction.

The passive device chip 600 may include a passive device provided therein. For example, the passive device may be a capacitor, a resistor, or an inductor. As an example, the passive device may be a capacitor having a first electrode and a second electrode, which are spaced apart from each other, and a dielectric material, which is interposed between the first and second electrodes. The first and second electrodes may be respectively connected to passive device pads 602 of the passive device chip 600. The passive device pads 602 may be wires or pads formed on a front surface of the passive device chip 600.

The passive device chip 600 may be mounted on the bottom surface of the first redistribution substrate 100. For example, the passive device chip 600 may be mounted on the first redistribution substrate 100 in a flip chip manner. In more detail, the passive device chip 600 may be electrically connected to the outer pads 130 of the first redistribution substrate 100 through passive device connection terminals 604. The passive device connection terminals 604 may be provided between the passive device pads 602 of the passive device chip 600 and the outer pads 130 of the first redistribution substrate 100.

According to an embodiment of the inventive concept, the bridge chip 240, which is provided on the first redistribution substrate 100 to connect the first and second semiconductor chips 210 and 220, may be provided as the module structure 200, along with the first and second semiconductor chips 210 and 220. Thus, it may be unnecessary to mount the bridge chip 240 on the bottom surface of the first redistribution substrate 100, and the bottom surface of the first redistribution substrate 100 may have a larger area, with the outer terminals 150 provided thereon. Accordingly, a larger number of the outer terminals 150 may be provided on the bottom surface of the first redistribution substrate 100. In addition, it may be possible to reduce the area of the first redistribution substrate 100 required to place the desired number of the outer terminals 150. Accordingly, it may be possible to increase an integration density of the semiconductor package or to reduce a size of the semiconductor package.

The conductive posts 300 may be disposed on the first redistribution substrate 100. The conductive posts 300 may be disposed on the outer portion of the first redistribution substrate 100. For example, the conductive posts 300 may be disposed to be horizontally spaced apart from the module structure 200. The conductive posts 300 may be disposed on the third substrate pads 126 of the first redistribution substrate 100. In more detail, each of the conductive posts 300 may contact a top surface of a corresponding one of the third substrate pads 126 of the first redistribution substrate 100. The conductive posts 300 may be a vertical connection structure, which is used to connect the first redistribution substrate 100 to the second redistribution substrate 400. The conductive posts 300 may correspond to vertical connection terminals. The conductive posts 300 may be pillar-shaped patterns, which extend in a direction perpendicular to the top surface of the first redistribution substrate 100. However, the inventive concept is not limited to this example, and in an embodiment, various structures for vertical interconnection may be provided in place of the conductive posts 300. A width of the conductive posts 300 may be constant in a vertical direction. That is, each of the conductive posts 300 may be a pillar-shaped pattern having a constant width. Alternatively, the width of the conductive posts 300 may decrease as a distance to the first redistribution substrate 100 decreases, unlike that shown in FIG. 1. The conductive posts 300 may include a conductive material. For example, the conductive posts 300 may include a metallic material (e.g., copper or tungsten).

Although not shown, each of the conductive posts 300 may further include a seed layer provided to enclose a side surface thereof. The seed layers may be provided to conformally cover bottom and side surfaces of the conductive posts 300. The seed layers may be formed of or include a metallic material (e.g., gold).

The second mold layer 350 may be provided on the first redistribution substrate 100. The second mold layer 350 on the first redistribution substrate 100 may enclose the module structure 200. The second mold layer 350 may cover the module structure 200. Accordingly, the second mold layer 350 may cover the first mold layer 230. The first mold layer 230 may be an inner mold layer of the semiconductor package, and the second mold layer 350 may be an outer mold layer of the semiconductor package. The second mold layer 350 may be provided to fill a space between the module structure 200 and the first redistribution substrate 100 and to enclose the third and fourth inner terminals 162 and 164. The second mold layer 350 may extend into the recess region RS of the first redistribution substrate 100. The second mold layer 350 may fill a space between an inner side surface and a bottom surface of the recess region RS and the bridge chip 240. The conductive posts 300 may be provided to vertically penetrate the second mold layer 350 and may be exposed to a region on the top surface of the second mold layer 350. Top surface of the second mold layer 350 and top surfaces of the conductive posts 300 may be substantially flat and may be coplanar with each other. The second mold layer 350 may include a molding member. In an embodiment, the molding member may include an insulating polymer material (e.g., an epoxy molding compound (EMC) or an Ajinomoto build-up film (ABF)). In the case where, as in the embodiment of FIG. 4, the module structure 200 does not have the under-fill layer 250, the second mold layer 350 may fill a space between the first and second semiconductor chips 210 and 220 and the bridge chip 240 and may eclose the first and second inner terminals 218 and 228.

The second redistribution substrate 400 may be provided on the second mold layer 350. The second redistribution substrate 400 may contact the top surfaces of the conductive posts 300 and the top surface of the second mold layer 350.

The second redistribution substrate 400 may include at least two second substrate interconnection layers, which are vertically stacked. Each of the second substrate interconnection layers may include a second substrate insulating pattern 410 and a second substrate interconnection pattern 420 in the second substrate insulating pattern 410. In the case where a plurality of the second substrate interconnection layers are provided, the second substrate interconnection pattern 420 of each second substrate interconnection layer may be electrically connected to the second substrate interconnection pattern 420 of another second substrate interconnection layer adjacent thereto.

The second substrate insulating pattern 410 may include an insulating polymer or a photoimageable dielectric (PID) material. For example, the photoimageable dielectric material may include at least one of photoimageable poly imide (PI), polybenzoxazole (PBO), phenol-based polymers, or benzocyclobutene-based polymers.

The second substrate interconnection pattern 420 may be provided on the second substrate insulating pattern 410. The second substrate interconnection pattern 420 may extend horizontally, on the second substrate insulating pattern 410. The second substrate interconnection pattern 420 may be provided on a top surface of the second substrate insulating pattern 410. The second substrate interconnection pattern 420 may extend above the top surface of the second substrate insulating pattern 410, thereby having a protruding shape. The second substrate interconnection pattern 420 on the second substrate insulating pattern 410 may be covered with another second substrate insulating pattern 410 thereon. The second substrate interconnection pattern 420, which is provided in the uppermost one of the second substrate interconnection layers, may be used as a substrate pad which is coupled with an upper package to be described below. As described above, the second substrate interconnection pattern 420 may be used as the pad or wire portion of the second substrate interconnection layer. For example, the second substrate interconnection pattern 420 may be an element for a horizontal redistribution in the second redistribution substrate 400. The second substrate interconnection pattern 420 may include a conductive material. For example, the second substrate interconnection pattern 420 may include a metallic material (e.g., copper).

The second substrate interconnection pattern 420 may have a damascene structure. For example, the second substrate interconnection pattern 420 may include a via portion protruding in a downward direction. The via portion may be configured to vertically connect the second substrate interconnection patterns 420, which are included in adjacent ones of the second substrate interconnection layers, to each other. For example, the via portion may extend from a bottom surface of the second substrate interconnection pattern 420 to penetrate the second substrate insulating pattern 410 and may be coupled to a top surface of the second substrate interconnection pattern 420 of another second substrate interconnection layer thereunder. Alternatively, the via portion may be used to connect the second substrate interconnection pattern 420 of the lowermost one of the second substrate interconnection layers to the conductive posts 300. For example, the via portion may extend from the bottom surface of the second substrate interconnection pattern 420 to penetrate the lowermost one of the second substrate insulating patterns 410 and may be coupled to the top surfaces of the conductive posts 300. An upper portion of the second substrate interconnection pattern 420, which is placed on the second substrate insulating pattern 410, may be a head portion serving as a horizontal line or a pad, and the via portion of the second substrate interconnection pattern 420 may be a tail portion. A horizontal width of the tail portion may be smaller than a horizontal width of the head portion. The horizontal width of the tail portion may decrease as a distance from the head portion of the second substrate interconnection pattern 420 increases. In other words, the tail portion may have a tapered shape. The second substrate interconnection pattern 420 may be a 'T'-shaped pattern.

An upper package 700 may be provided on the lower package. For example, the semiconductor package may be a package-on-package (PoP) structure, in which the upper package 700 is mounted on the lower package. The upper package 700 may be placed over the first semiconductor chip 210. The upper package 700 may be spaced apart from the second semiconductor chip 220, when viewed in a plan view. The upper package 700 may be spaced apart from the second semiconductor chip 220, when viewed in a plan view. In some embodiments, the upper package 700 does not cover the second semiconductor chip 220. FIG. 1 illustrates an example, in which the upper package 700 is horizontally spaced apart from the second semiconductor chip 220, but the inventive concept is not limited to this example. Unlike the illustrated structure, a portion of the upper package 700 may extend to a region on the second semiconductor chip 220. Alternatively, the upper package 700 may cover a portion of the first semiconductor chip 210, but not a remaining portion of the first semiconductor chip 210. In other words, the upper package 700 may not cover the entirety of the first semiconductor chip 210. Hereinafter, aspects of the inventive concept location of the upper package 700 in relation to the first semiconductor chip 210 and second semiconductor chip 220 will be described with reference to the embodiment of FIG. 1. The upper package 700 may include an upper package substrate 710, an upper package chip 720, and an upper mold layer 730.

The upper package substrate 710 may be a printed circuit board (PCB). Alternatively, the upper package substrate 710 may be a redistribution substrate. Upper substrate pads 712 may be disposed on a bottom surface of the upper package substrate 710.

The upper package chip 720 may be disposed on the upper package substrate 710. The upper package chip 720 may include integrated circuits, and the integrated circuits may include a memory circuit, a logic circuit, or combinations thereof. The upper package chip 720 may be a semiconductor chip of a kind different from the first and second semiconductor chips 210 and 220. In an embodiment, the upper package chip 720 may be a memory chip. The upper package chip 720 may be electrically connected to the upper package substrate 710 through upper connection terminals 722. FIG. 1 illustrates an example, in which the upper package chip 720 is mounted in a flip chip manner, but the upper package chip 720 may be mounted in various manners (e.g., using a wire bonding method).

The upper mold layer 730 may be provided on the upper package substrate 710 to cover the upper package chip 720. The upper mold layer 730 may include, for example, an insulating polymer (e.g., an epoxy-based polymer).

Intermediate connection terminals 714 may be disposed between the lower package and the upper package 700. The intermediate connection terminals 714 may be interposed between the uppermost ones of the second substrate interconnection patterns 420 of the second redistribution substrate 400 and the upper substrate pads 712 of the upper package substrate 710 to electrically connect the second substrate interconnection pattern 420 to the upper substrate pads 712. Accordingly, the upper package 700 may be electrically connected to the first and second semiconductor chips 210 and 220 and the outer terminals 150 through the intermediate connection terminals 714, the second redistribution substrate 400, the conductive posts 300, and the first redistribution substrate 100.

A heat-dissipation member 800 may be provided on the lower package. The heat-dissipation member 800 may be a heat radiator. For example, the heat-dissipation member 800 may be disposed on the second redistribution substrate 400. The heat-dissipation member 800 may be disposed to be horizontally spaced apart from the upper package 700. The heat-dissipation member 800 may be placed over the second semiconductor chip 220. The heat-dissipation member 800 may be disposed to be in contact with a top surface of the second redistribution substrate 400. The heat-dissipation member 800 may be attached to the second redistribution substrate 400 using an adhesive film 802. In an embodiment, the adhesive film 802 may include a thermal interface material (TIM) (e.g., thermal grease). The heat-dissipation member 800 may be used to exhaust heat, which is generated from the second semiconductor chip 220, to the outside. The heat-dissipation member 800 may include a heat sink or the like.

According to an embodiment of the inventive concept, another semiconductor chip or package (e.g., the upper package 700) may not be provided in a region on the second semiconductor chip 220. Thus, it may be possible to prevent another semiconductor chip or package from hindering the dissipation of heat generated by the second semiconductor chip 220. In addition, since the heat-dissipation member 800 is attached to the top surface of the second redistribution substrate 400 on the second semiconductor chip 220, the heat generated by the second semiconductor chip 220 may be more efficiently exhausted to the outside. Thus, it may be possible to improve the heat-dissipation efficiency and electric characteristics of the semiconductor package.

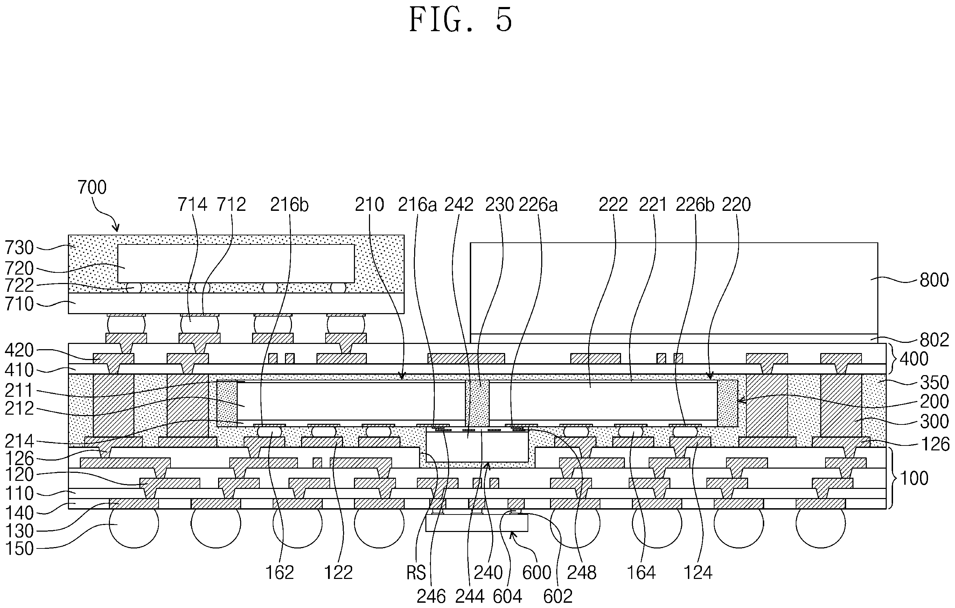

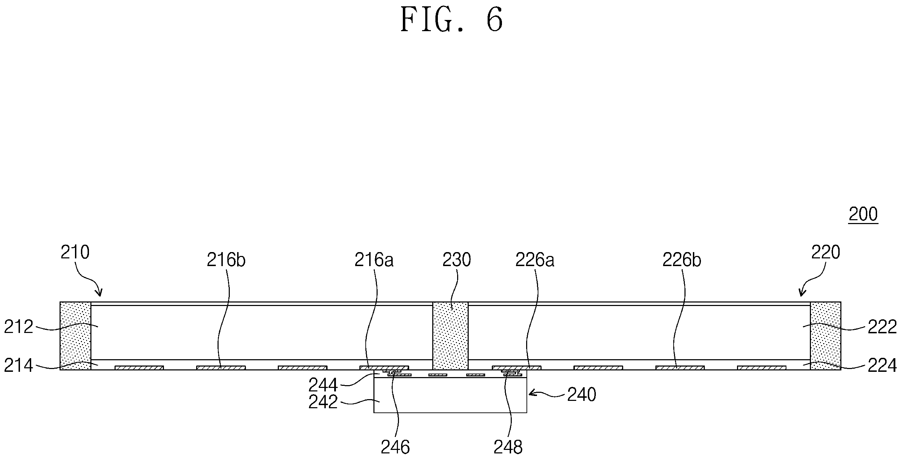

FIG. 5 is a sectional view illustrating a semiconductor package according to an embodiment of the inventive concept. FIG. 6 is a sectional view illustrating a module structure.

FIG. 1 illustrates an example, in which the bridge chip 240 is mounted on the first and second semiconductor chips 210 and 220 using the first and second inner terminals 218 and 228, but the inventive concept is not limited to this example.

Referring to FIGS. 5 and 6, the top surfaces of the first and second bridge pads 246 and 248 of the bridge chip 240 and the top surface of the bridge interconnection layer 244 may be substantially flat and may be coplanar with each other. Bottom surfaces of the first chip pads 216a of the first semiconductor chip 210 and the bottom surface of the first chip interconnection layer 214 may be substantially flat and may be coplanar with each other. Bottom surfaces of the third chip pads 226a of the second semiconductor chip 220 and bottom surface of the second chip interconnection layer 224 may be substantially flat and may be coplanar with each other. The first bridge pads 246 of the bridge chip 240 may be directly connected to the first chip pads 216a of the first semiconductor chip 210, and the second bridge pads 248 of the bridge chip 240 may be directly connected to the third chip pads 226a of the second semiconductor chip 220.

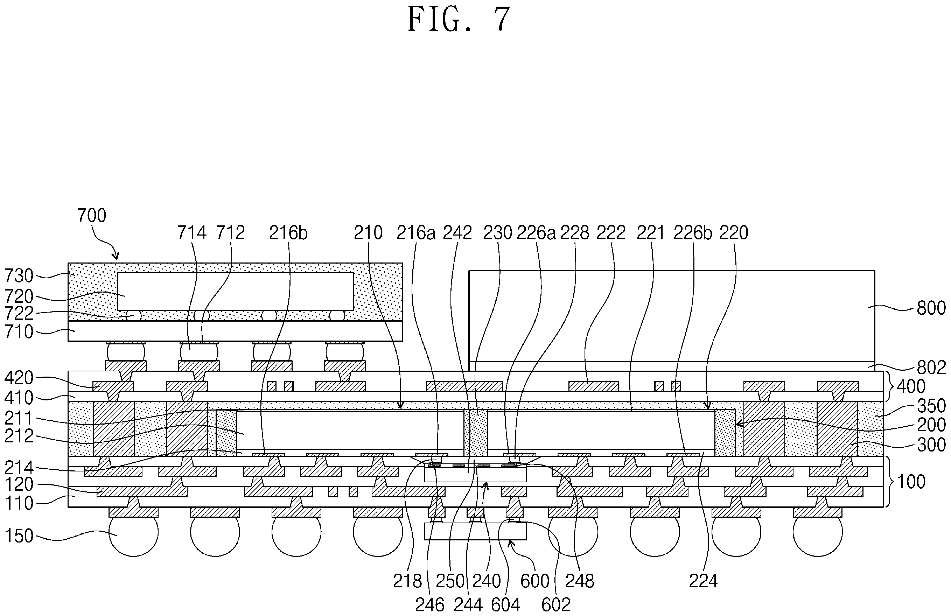

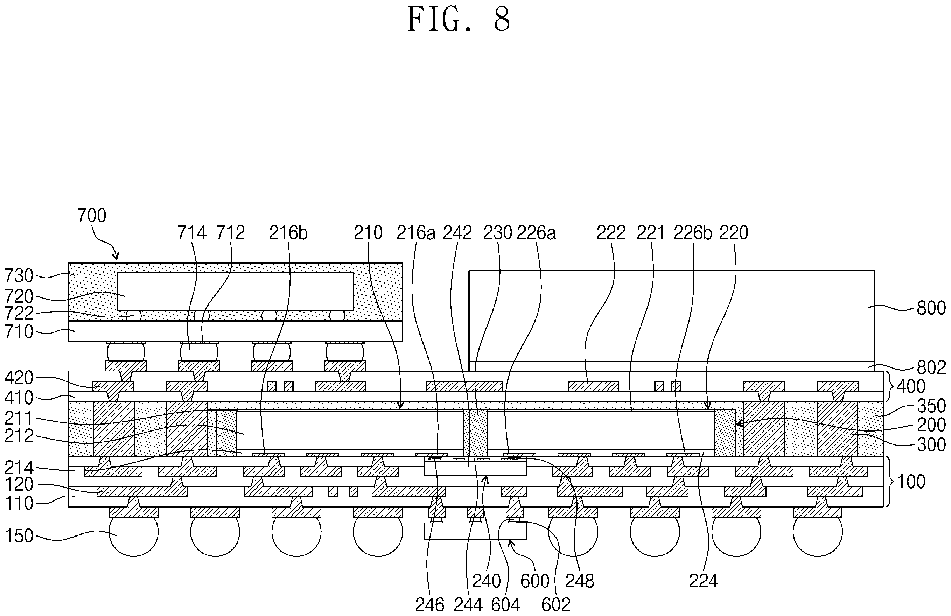

FIGS. 7 and 8 are sectional views illustrating a semiconductor package according to an embodiment of the inventive concept.

FIG. 1 illustrates an example, in which the module structure 200 is mounted on the first redistribution substrate 100 using the third and fourth inner terminals 162 and 164, but the inventive concept is not limited to this example.

Referring to FIG. 7, bottom surfaces of the second chip pads 216b of the first semiconductor chip 210 and the bottom surface of the first chip interconnection layer 214 may be substantially flat and may be coplanar with each other. Bottom surfaces of the fourth chip pads 226b of the second semiconductor chip 220 and the bottom surface of the second chip interconnection layer 224 may be substantially flat and may be coplanar with each other. The second chip pads 216b of the first semiconductor chip 210 and the fourth chip pads 226b of the second semiconductor chip 220 may be directly connected to the first substrate interconnection patterns 120 of the first redistribution substrate 100, respectively.

A mold layer 350 may be provided on the first redistribution substrate 100 to cover the module structure 200, the conductive posts 300 may be provided near the module structure 200 (e.g., adjacent to the module structure 200) to vertically penetrate the mold layer 350, and the second redistribution substrate 400 may be provided on the mold layer 350. Here, the bottom surface of the first semiconductor chip 210, the bottom surface of the second semiconductor chip 220, and the bottom surfaces of the conductive posts 300 may be exposed to a region under the bottom surface of the mold layer 350. The bottom surface of the first semiconductor chip 210, the bottom surface of the second semiconductor chip 220, the bottom surfaces of the conductive posts 300, and the bottom surface of the mold layer 350 may be substantially flat and may be coplanar with each other.

The first redistribution substrate 100 may be provided below the mold layer 350. The first redistribution substrate 100 may include at least two first substrate interconnection layers, which are sequentially stacked. Each of the first substrate interconnection layers may include the first substrate insulating pattern 110 and the first substrate interconnection pattern 120 in the first substrate insulating pattern 110. The first substrate insulating pattern 110 may cover the bottom surface of the first semiconductor chip 210, the bottom surface of the second semiconductor chip 220, the bottom surfaces of the conductive posts 300, and the bottom surface of the mold layer 350. The first substrate insulating pattern 110 may embed the bridge chip 240, on the bottom surface of the module structure 200. The first substrate insulating pattern 110 may be in contact with side and bottom surfaces of the bridge chip 240.

The first substrate interconnection pattern 120 may have a damascene structure. For example, the first substrate interconnection pattern 120 may include a via portion protruding in an upward direction. The via portion may be configured to vertically connect the first substrate interconnection patterns 120, which are included in adjacent ones of the first substrate interconnection layers, to each other. Alternatively, the via portion may be used to connect the first substrate interconnection pattern 120 of the uppermost one of the first substrate interconnection layers to a corresponding one of the second chip pads 216b, the fourth chip pads 226b, and the conductive posts 300. For example, the via portion may extend from the top surface of the first substrate interconnection pattern 120 to penetrate the first substrate insulating pattern 110 and may be connected to the bottom surface of the first substrate interconnection pattern 120 of another first substrate interconnection layer thereon. Alternatively, the via portion may extend from the top surface of the first substrate interconnection pattern 120 to penetrate the uppermost one of the first substrate insulating patterns 110 and may be connected to the bottom surfaces of the second chip pads 216b, the bottom surfaces of the fourth chip pads 226b, or the bottom surfaces of the conductive posts 300. The first substrate interconnection pattern 120 may have an inverted 'T' shape.

In the lowermost one of the first substrate interconnection layers, the first substrate interconnection pattern 120 may be exposed to a region under the bottom surface of the first substrate insulating pattern 110. The lowermost ones of the first substrate interconnection patterns 120 may be used as outer pads of the first redistribution substrate 100.

In another embodiment, as shown in FIG. 8, the first bridge pads 246 of the bridge chip 240 may be directly connected to the first chip pads 216a of the first semiconductor chip 210, and the second bridge pads 248 of the bridge chip 240 may be directly connected to the third chip pads 226a of the second semiconductor chip 220. In this case, a distance from the bottom surfaces of the first and second semiconductor chips 210 and 220 to the bottom surface of the bridge chip 240 may be reduced. Thus, the first redistribution substrate 100 may have a larger space for the first substrate interconnection pattern 120.

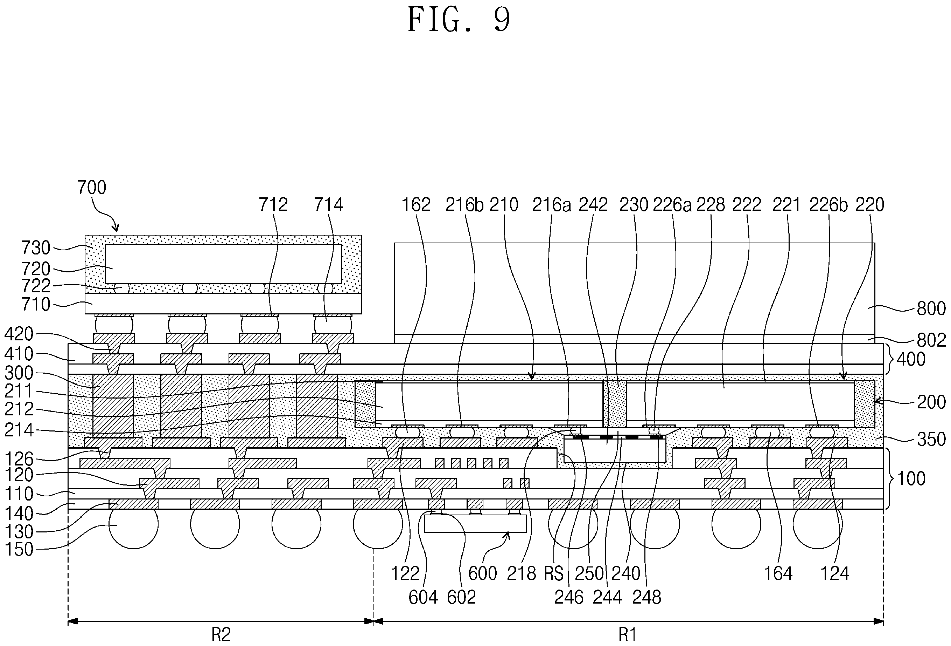

FIGS. 9 to 11 are sectional views illustrating a semiconductor package according to an embodiment of the inventive concept.

Referring to FIG. 9, the first redistribution substrate 100 may have a first region R1 and a second region R2. The first region R1 may be a region of the first redistribution substrate 100, on which the module structure 200 is mounted, and the second region R2 may be a region of the first redistribution substrate 100, on which the conductive posts 300 are provided. The second region R2 may be located near or around the first region R1. The first region R1 and the second region R2 may be disposed to be horizontally spaced apart from each other. The recess region RS of the first redistribution substrate 100 may be disposed on the first region R1.

The module structure 200 may be disposed on the first region R1 of the first redistribution substrate 100. The conductive posts 300 may be disposed on the second region R2 of the first redistribution substrate 100.

The upper package 700 may be provided on the lower package. The upper package 700 may be placed on the first region R1. The upper package 700 may be spaced apart from the first region R1, when viewed in a plan view. In another embodiment, a portion of the upper package 700 may be extended to a region on the first region R1. Here, the upper package 700 may be disposed to be horizontally spaced apart from the second semiconductor chip 220. In some embodiments, though not shown, the upper package 700 may cover a portion of the first semiconductor chip 210 when viewed from a plan view, but not a remaining portion of the first semiconductor chip 210. In this case, the upper package 700 may not cover the entirety of the first semiconductor chip 210. In other embodiments as depicted in FIG. 9, the upper package 700 does cover a portion of the first semiconductor chip 210, when viewed from a plan view.

The heat-dissipation member 800 may be placed on the second region R2. The heat-dissipation member 800 may be placed on the module structure 200.

According to an embodiment of the inventive concept, other than the bridge chip 240, another semiconductor chip or package may not be provided in a region on the first semiconductor chip 210 and the second semiconductor chip 220 (e.g., as can be seen from the plan view). Thus, it may be possible to prevent another semiconductor chip or package from hindering the dissipation of heat generated by the first and second semiconductor chips 210 and 220. Furthermore, since the heat-dissipation member 800 is attached to the top surface of the second redistribution substrate 400 on the first and second semiconductor chips 210 and 220, heat generated by the first and second semiconductor chips 210 and 220 may be more efficiently exhausted to the outside. Thus, it may be possible to improve the heat-dissipation efficiency and electric characteristics of the semiconductor package.

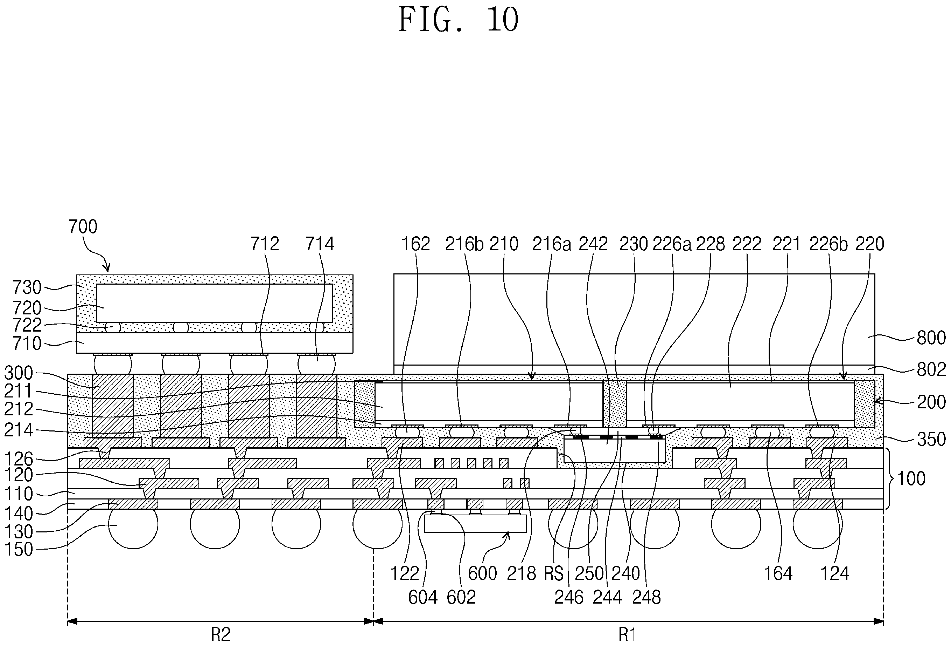

In another embodiment, as shown in FIG. 10, the lower package of the semiconductor package may not include the second redistribution substrate 400.

The top surfaces of the conductive posts 300 may be exposed to a region on a top surface of the mold layer 350. The top surfaces of the conductive posts 300 and the top surface of the mold layer 350 may be substantially flat and may be coplanar with each other. In another embodiment, the top surface of the mold layer 350 may have recesses, which are formed on the second region R2 and are recessed toward the first redistribution substrate 100, and the top surfaces of the conductive posts 300 may be exposed on bottom surfaces of the recesses. For example, a level of the top surfaces of the conductive posts 300 may be lower than a level of the top surface of the mold layer 350.

The upper package 700 may be provided on the lower package. The intermediate connection terminals 714 may be disposed between the lower package and the upper package 700. The intermediate connection terminals 714 may be interposed between the conductive posts 300 and the upper substrate pads 712 of the upper package substrate 710 to electrically connect the conductive posts 300 to the upper substrate pads 712.

The heat-dissipation member 800 may be provided on the lower package. The heat-dissipation member 800 may be disposed on the mold layer 350. The heat-dissipation member 800 may be located on the second region R2. The heat-dissipation member 800 may be placed over the module structure 200. The heat-dissipation member 800 may be attached to the mold layer 350 using the adhesive film 802.

According to an embodiment of the inventive concept, since the heat-dissipation member 800 is directly attached to the mold layer 350, heat, which is generated from the first and second semiconductor chips 210 and 220, may be easily exhausted to the outside through the heat-dissipation member 800. Thus, it may be possible to improve the heat-dissipation efficiency and electric characteristics of the semiconductor package.

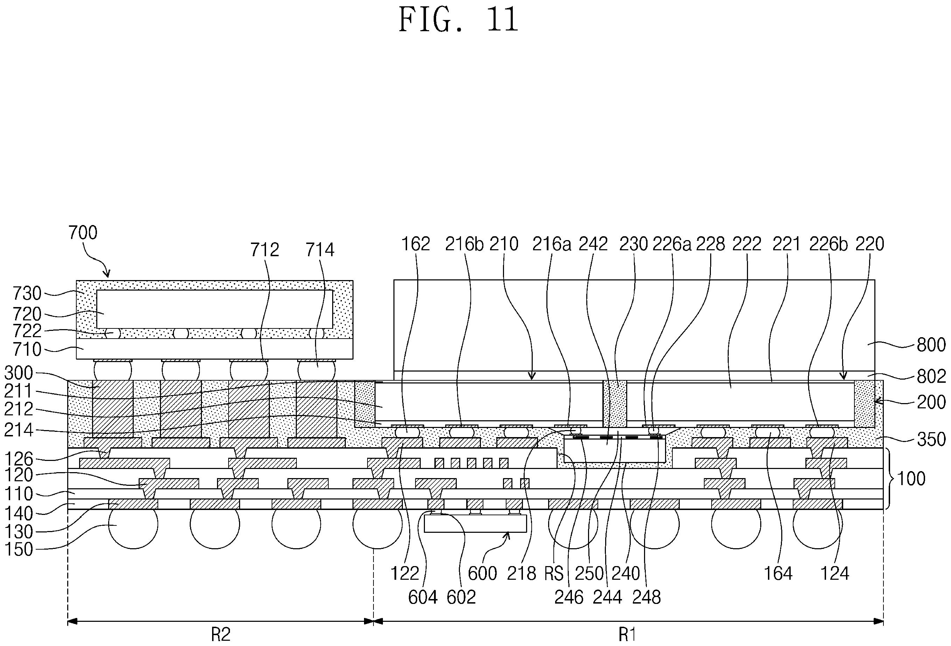

FIG. 10 illustrates the mold layer 350 covering the module structure 200, but the inventive concept is not limited to this example. As shown in FIG. 11, the top surfaces of the conductive posts 300 and a top surface of the module structure 200 may be exposed to a region on the top surface of the mold layer 350. The top surfaces of the conductive posts 300, the top surface of the module structure 200, and the top surface of the mold layer 350 may be substantially flat and may be coplanar with each other.

The heat-dissipation member 800 may be disposed on the mold layer 350. The heat-dissipation member 800 may be disposed to be connected to the top surface of the mold layer 350. The heat-dissipation member 800 may be attached to the mold layer 350 and the module structure 200, which is exposed to the outside of the mold layer 350 near the top surface of the mold layer 350, for example, using only the adhesive film 802. Alternatively, the heat-dissipation member 800 may be attached to the mold layer 350 and the first and second semiconductor chips 210 and 220, which are exposed to the outside of the mold layer 350 near the top surface of the mold layer 350, using the adhesive film 802.

According to an embodiment of the inventive concept, since the heat-dissipation member 800 is attached to the top surface of the module structure 200 only through an adhesive film 802, heat, which is generated from the first and second semiconductor chips 210 and 220, may be easily exhausted to the outside through the heat-dissipation member 800. Thus, it may be possible to improve the heat-dissipation efficiency and electric characteristics of the semiconductor package.

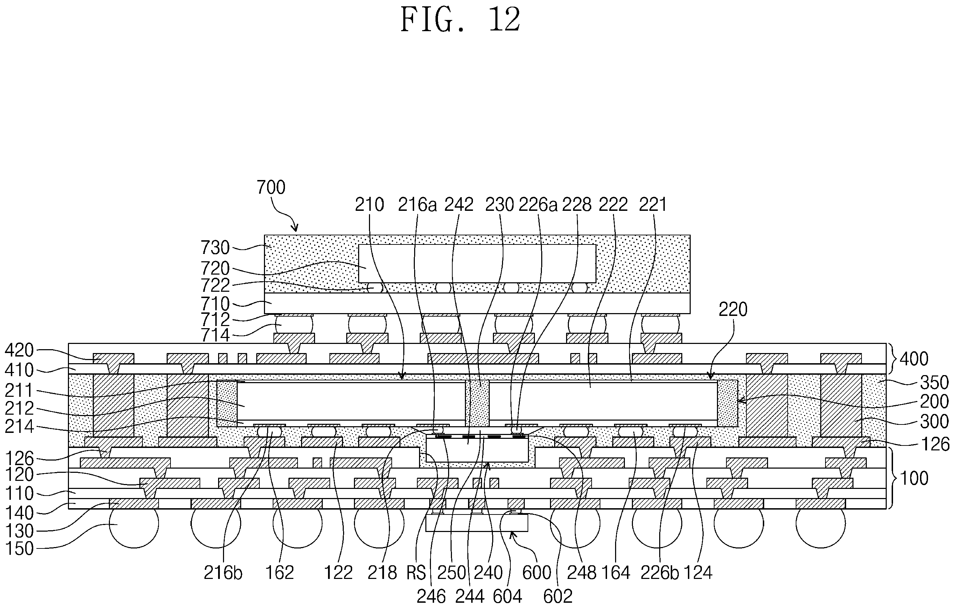

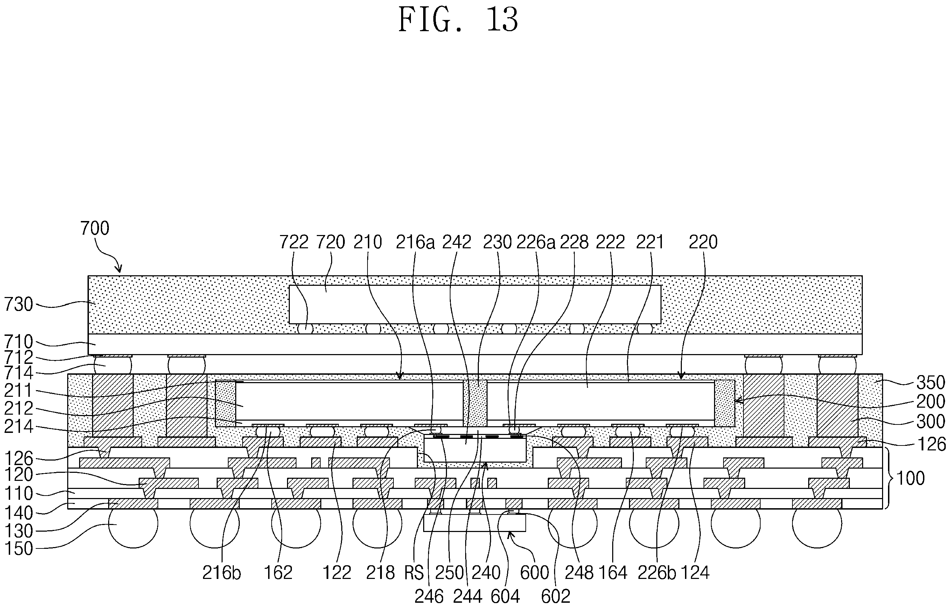

FIGS. 12 and 13 are sectional views illustrating a semiconductor package according to an embodiment of the inventive concept.

Referring to FIG. 12, the semiconductor package may not have a heat-dissipation member. The upper package 700 may be provided over the module structure 200. Alternatively, unlike the illustrated structure, the upper package 700 may be placed on one of the first and second semiconductor chips 210 and 220 and may be spaced apart from the other of the first and second semiconductor chips 210 and 220 in a plan view.

In another embodiment, the upper package 700 of the semiconductor package may be provided to have a large size, as shown in FIG. 13. The lower package of the semiconductor package may not include the second redistribution substrate 400. The intermediate connection terminals 714 may be disposed between the lower package and the upper package 700. The intermediate connection terminals 714 may be interposed between the conductive posts 300 and the upper substrate pads 712 of the upper package substrate 710 to electrically connect the conductive posts 300 to the upper substrate pads 712.

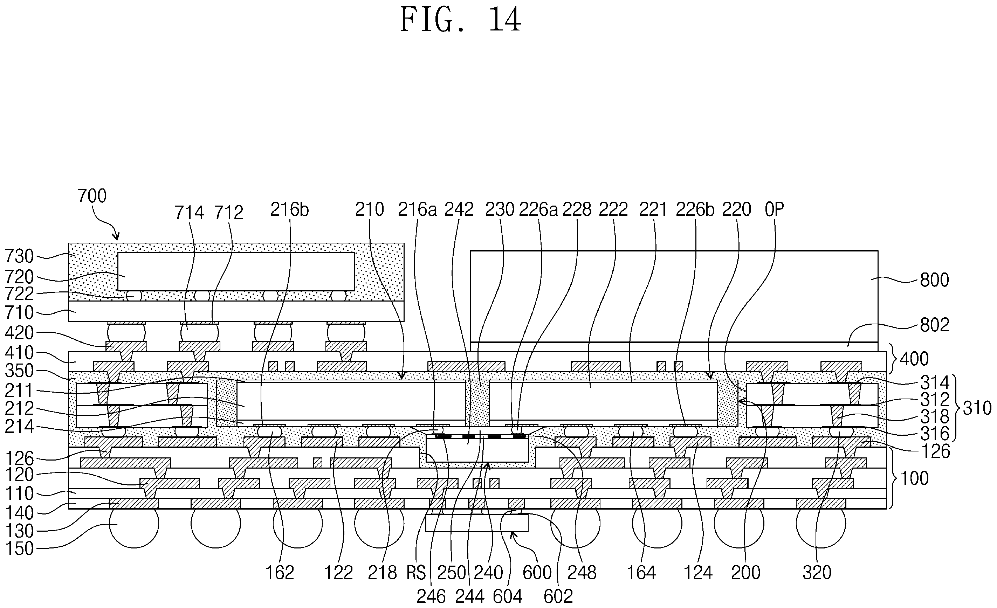

FIG. 14 is a sectional view illustrating a semiconductor package according to an embodiment of the inventive concept.

Referring to FIG. 14, the lower package of the semiconductor package may include a connection substrate 310, which is provided in place of the conductive posts.

The connection substrate 310 may be disposed on the first redistribution substrate 100. The connection substrate 310 may be spaced apart from the top surface of the first redistribution substrate 100. An opening OP may be provided to penetrate the connection substrate 310. For example, the opening OP may have an open hole shape connecting top and bottom surfaces of the connection substrate 310. The connection substrate 310 may correspond to a vertical connection structure, which is provided near or around the module structure 200 to vertically connect the first redistribution substrate 100 to the second redistribution substrate 400.

The connection substrate 310 may include a base layer 312 and a conductive portion, which is an interconnection pattern provided in the base layer 312. In an embodiment, the base layer 312 may include an insulating material.

The conductive portion may include upper pads 314, vias 318, and lower pads 316. The upper pads 314 may be disposed in an upper portion of the connection substrate 310. The upper pads 314 may be exposed to a region on the top surface of the connection substrate 310. The lower pads 316 may be disposed on the bottom surface of the connection substrate 310. The vias 318 may be penetration electrodes, which are provided to penetrate the base layer 312 and to electrically connect the upper pads 314 to the lower pads 316.

The connection substrate 310 may be mounted on the first redistribution substrate 100. For example, the connection substrate 310 may be electrically connected to the first redistribution substrate 100 through connection substrate terminals 320. The connection substrate terminals 320 may be provided between the third substrate pads 126 of the first redistribution substrate 100 and the lower pads 316 of the connection substrate 310.

The module structure 200 may be disposed in the opening OP of the connection substrate 310. The module structure 200 may have an area smaller than the opening OP, when viewed in a plan view. For example, the module structure 200 may be spaced apart from an inner side surface of the opening OP.

The mold layer 350 may be provided on the first redistribution substrate 100 to cover the connection substrate 310 and the module structure 200. The mold layer 350 may fill a space between the connection substrate 310 and the module structure 200. For example, the mold layer 350 may fill a remaining portion of the opening OP of the connection substrate 310. Here, the upper pads 314 may be electrically connected to the second substrate interconnection pattern 420 of the second redistribution substrate 400. In more detail, the second substrate interconnection pattern 420 of the second redistribution substrate 400 may be provided to penetrate the second substrate insulating pattern 410 and the mold layer 350 and may be coupled to the upper pads 314.

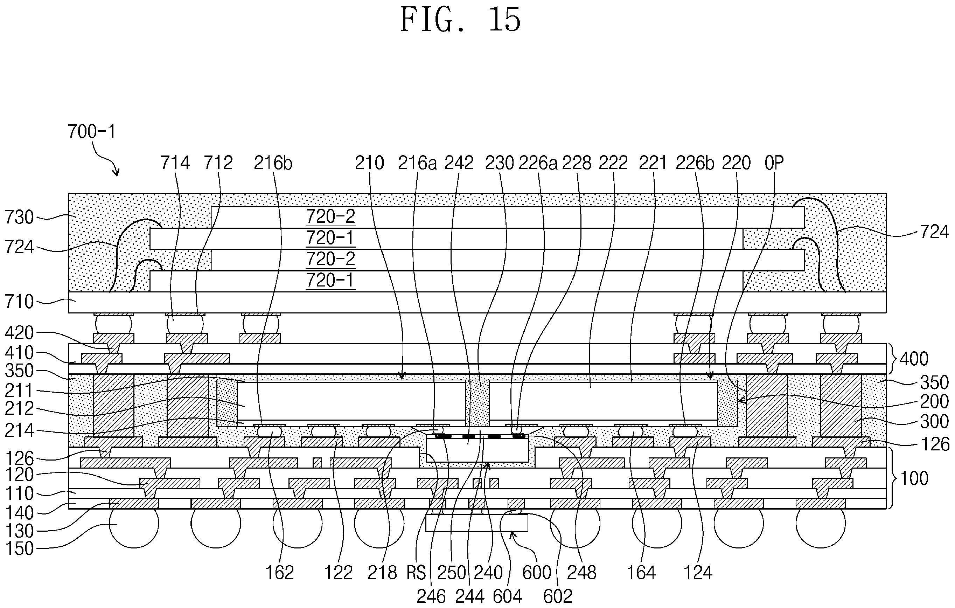

FIG. 15 is a sectional view illustrating a semiconductor package according to an embodiment of the inventive concept.

Referring to FIG. 15, an upper package 700-1 may be provided on the lower package. A width of the upper package 700-1 may be equal or similar to a width of the lower package. Alternatively, the width of the upper package 700-1 may be smaller than the width of the lower package. The upper package 700-1 may include the upper package substrate 710, upper package chips 720-1 and 720-2, and the upper mold layer 730.

The upper package chips 720-1 and 720-2 may be disposed on the upper package substrate 710. The upper package chips 720-1 and 720-2 may have first upper semiconductor chips 720-1 and second upper semiconductor chips 720-2. The first upper semiconductor chips 720-1 and the second upper semiconductor chips 720-2 may be alternately stacked on top of each other. The first upper semiconductor chips 720-1 may be aligned with each other in a direction perpendicular to a top surface of the upper package substrate 710 (e.g., to have all four edges aligned from a plan view). The second upper semiconductor chips 720-2 may be aligned with each other in the direction perpendicular to the top surface of the upper package substrate 710 (e.g., to have all four edges aligned from a plan view). The first upper semiconductor chips 720-1 may be provided to protrude from the second upper semiconductor chips 720-2 adjacent thereto in a first direction parallel to the top surface of the upper package substrate 710. The second upper semiconductor chips 720-2 may be provided to protrude from the first upper semiconductor chips 720-1 adjacent thereto in an opposite direction of the first direction. The first upper semiconductor chips 720-1 and the second upper semiconductor chips 720-2 may be semiconductor chips of the same kind. The upper package chips 720-1 and 720-2 may include integrated circuits, and the integrated circuits may include a memory circuit, a logic circuit, or combinations thereof. The upper package chips 720-1 and 720-2 may be semiconductor chips of a different kind from the first and second semiconductor chips 210 and 220. In an embodiment, the upper package chips 720-1 and 720-2 may be memory chips. The upper package chips 720-1 and 720-2 may be electrically connected to the upper package substrate 710 through bonding wires 724. FIG. 15 illustrates an example of a method for stacking and mounting the upper package chips 720-1 and 720-2, but the inventive concept is not limited to this example.

The upper mold layer 730 may be provided on the upper package substrate 710 to cover the upper package chips 720-1 and 720-2.

The intermediate connection terminals 714 may be disposed between the lower package and the upper package 700. The intermediate connection terminals 714 may electrically connect the second substrate interconnection pattern 420 to the upper substrate pads 712.

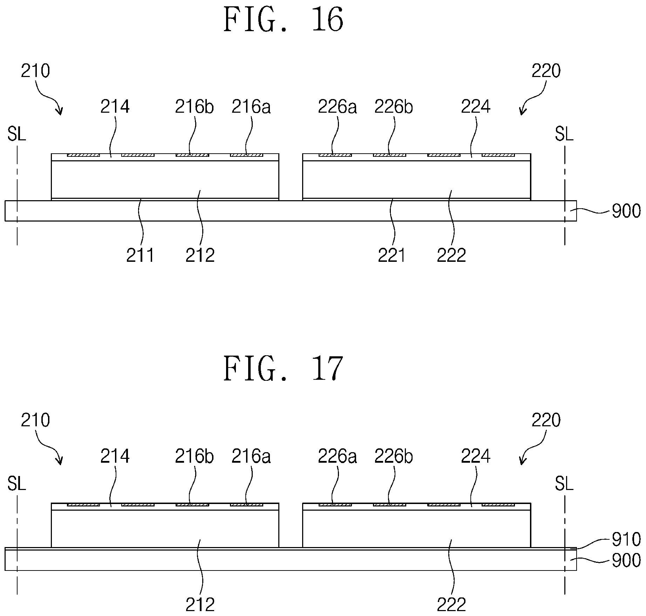

FIGS. 16 to 28 are sectional views illustrating a method of fabricating a semiconductor package, according to an embodiment of the inventive concept.

Referring to FIG. 16, a first carrier substrate 900 may be provided. The first carrier substrate 900 may be an insulating substrate containing glass or polymeric materials or a conductive substrate containing a metallic material.

The first and second semiconductor chips 210 and 220 may be attached to the first carrier substrate 900. The first and second semiconductor chips 210 and 220 may have the same or similar features as those in the embodiment described with reference to FIGS. 1 to 15. The first adhesive layer 211 may be provided on the rear surface of the first semiconductor chip 210 (i.e., the bottom surface of the first base layer 212). The second adhesive layer 221 may be provided on the rear surface of the second semiconductor chip 220 (i.e., the bottom surface of the second base layer 222). The first and second semiconductor chips 210 and 220 may be attached to the first carrier substrate 900 using the first and second adhesive layers 211 and 221.

Alternatively, as shown in FIG. 17, a preliminary adhesive layer 910 may be provided on the first carrier substrate 900. The preliminary adhesive layer 910 may cover the entire top surface of the first carrier substrate 900. The first and second semiconductor chips 210 and 220 may be attached to the preliminary adhesive layer 910. Hereinafter, the inventive concept will be described with reference to the embodiment of FIG. 16.

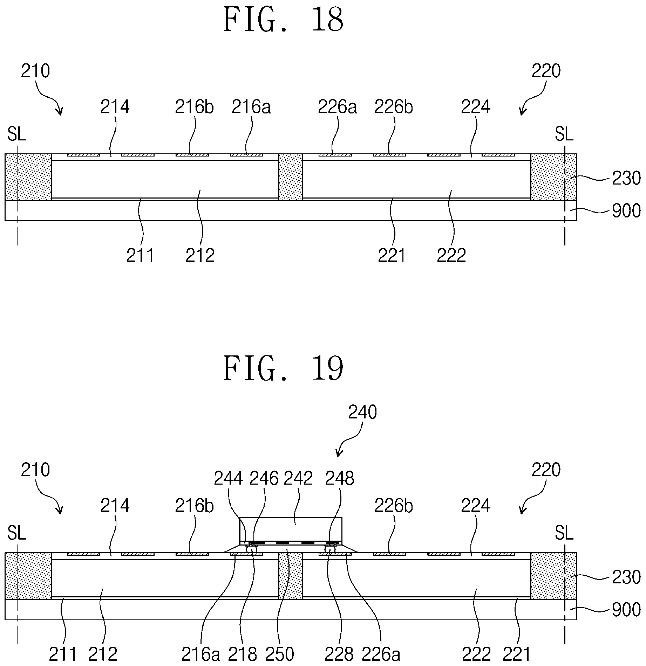

Referring to FIG. 18, the first mold layer 230 may be formed on the first carrier substrate 900. For example, the first mold layer 230 may be formed by forming a molding material on the first carrier substrate 900 to cover the first and second semiconductor chips 210 and 220 and curing the molding material. The active surfaces of the first and second semiconductor chips 210 and 220 may be exposed to a region on the top surface of the first mold layer 230. For example, the first and second chip pads 216a and 216b of the first chip interconnection layer 214 of the first semiconductor chip 210 and the third and fourth chip pads 226a and 226b of the second chip interconnection layer 224 of the second semiconductor chip 220 may be exposed to a region on the top surface of the first mold layer 230.

Referring to FIG. 19, the bridge chip 240 may be provided. The bridge chip 240 may have the same or similar features as the bridge chip 240 described with reference to FIGS. 1 to 15.

The bridge chip 240 may be mounted on the first and second semiconductor chips 210 and 220. For example, the first inner terminals 218 may be provided on the first bridge pads 246 of the bridge chip 240, and the second inner terminals 228 may be provided on the second bridge pads 248. The under-fill layer 250 may be provided on the bottom surface of the bridge chip 240. The bridge chip 240 may be disposed on the first mold layer 230 in such a way that the first inner terminals 218 are aligned with the first chip pads 216a and the second inner terminals 228 are aligned with the third chip pads 226a. Next, a reflow process may be performed to bond the first inner terminals 218 to the first bridge pads 246 and the first chip pads 216a and to bond the second inner terminals 228 to the second bridge pads 248 and the third chip pads 226a.

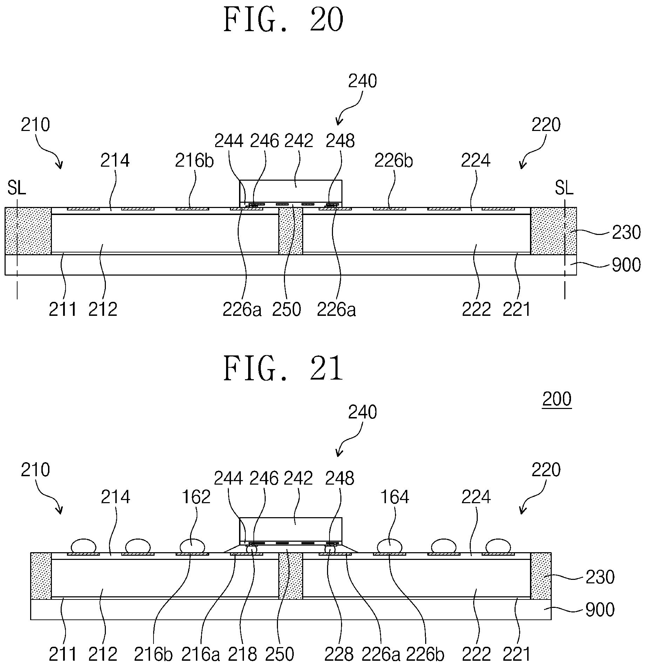

In another embodiment, as shown in FIG. 20, the bridge chip 240 may be disposed over the first mold layer 230 in such a way that the first bridge pads 246 are aligned with the first chip pads 216a and the second bridge pads 248 are aligned with the third chip pads 226a. The first bridge pads 246 may be bonded to the first chip pads 216a, and the second bridge pads 248 may be bonded to the third chip pads 226a. For example, each of the first and second bridge pads 246 and 248 may be bonded to a corresponding one of the first and third chip pads 216a and 226a, thereby forming a single object. In an embodiment, the first and second bridge pads 246 and 248 may be naturally bonded to the first and third chip pads 216a and 226a. In detail, the first and second bridge pads 246 and 248 and the first and third chip pads 216a and 226a may be formed of the same material (e.g., copper), and the first and second bridge pads 246 and 248 and the first and third chip pads 216a and 226a may be bonded to each other through an intermetal hybrid bonding process, which is caused by the surface activation at an interface between the first and second bridge pads 246 and 248 and the first and third chip pads 216a and 226a, which are in contact with each other. Hereinafter, the inventive concept will be described with reference to the embodiment of FIG. 19.

Referring to FIG. 21, the module structure 200 may be formed by cutting the second mold layer 350 along a sawing line SL.

The third inner terminals 162 may be provided on the second chip pads 216b of the first semiconductor chip 210, and the fourth inner terminals 164 may be provided on the fourth chip pads 226b of the second semiconductor chip 220.

Next, the first carrier substrate 900 may be removed.

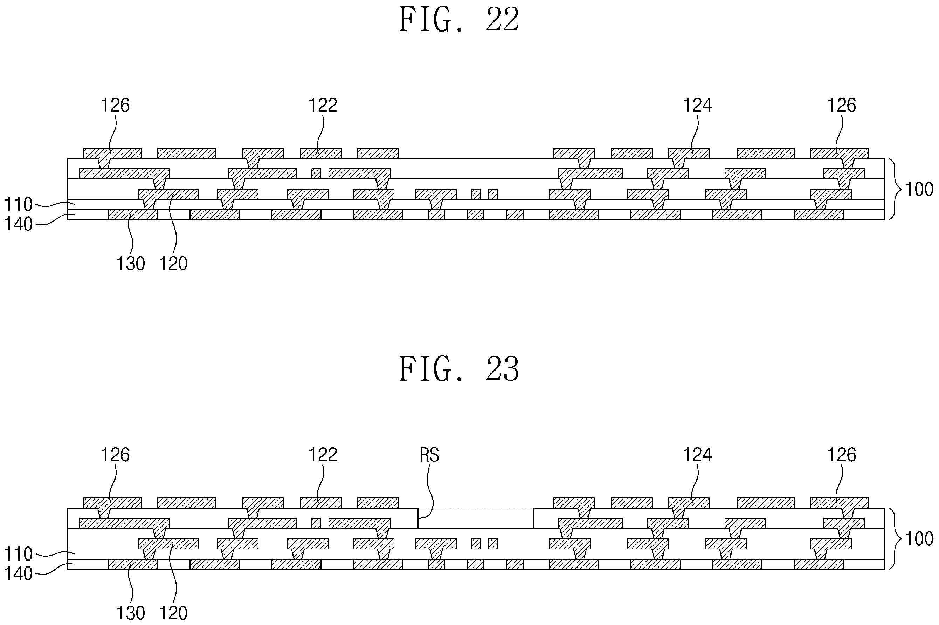

Referring to FIG. 22, the first redistribution substrate 100 may be formed. For example, the substrate protection layer 140 may be provided. The substrate protection layer 140 may be formed by a deposition process or a coating process. The outer pads 130 may be formed in the substrate protection layer 140. For example, the formation of the outer pads 130 may include patterning the substrate protection layer 140 to form openings for the outer pads 130, forming a seed layer to conformally cover the openings, and performing a plating process using the seed layer as a seed to fill the openings.

The first substrate insulating pattern 110 may be formed on the substrate protection layer 140. The first substrate insulating pattern 110 may be formed using a deposition process or a coating process. The first substrate interconnection pattern 120 may be formed on the first substrate insulating pattern 110. For example, the formation of the first substrate interconnection pattern 120 may include patterning the first substrate insulating pattern 110 to form openings exposing the outer pads 130, forming a seed layer to conformally cover the top surface of the first substrate insulating pattern 110 and inner surfaces of the openings, performing a plating process using the seed layer as a seed to form a conductive layer, which covers the first substrate insulating pattern 110 and is coupled to the outer pads 130, and patterning the conductive layer.

As a result of the above process, one first substrate interconnection layer may be formed to include the first substrate insulating pattern 110, which is provided on the substrate protection layer 140 and the outer pads 130, and the first substrate interconnection pattern 120, which is provided in the first substrate insulating pattern 110. The first redistribution substrate 100 may be formed by repeating a process of forming the first substrate interconnection layer. The first substrate interconnection pattern 120, which is provided in the uppermost one of the first substrate interconnection layers, may be the first to third substrate pads 122, 124, and 126, which will be described below.

Referring to FIG. 23, the recess region RS may be formed in the first redistribution substrate 100. For example, the recess region RS may be formed by patterning at least one of the upper ones of the first substrate insulating patterns 110.

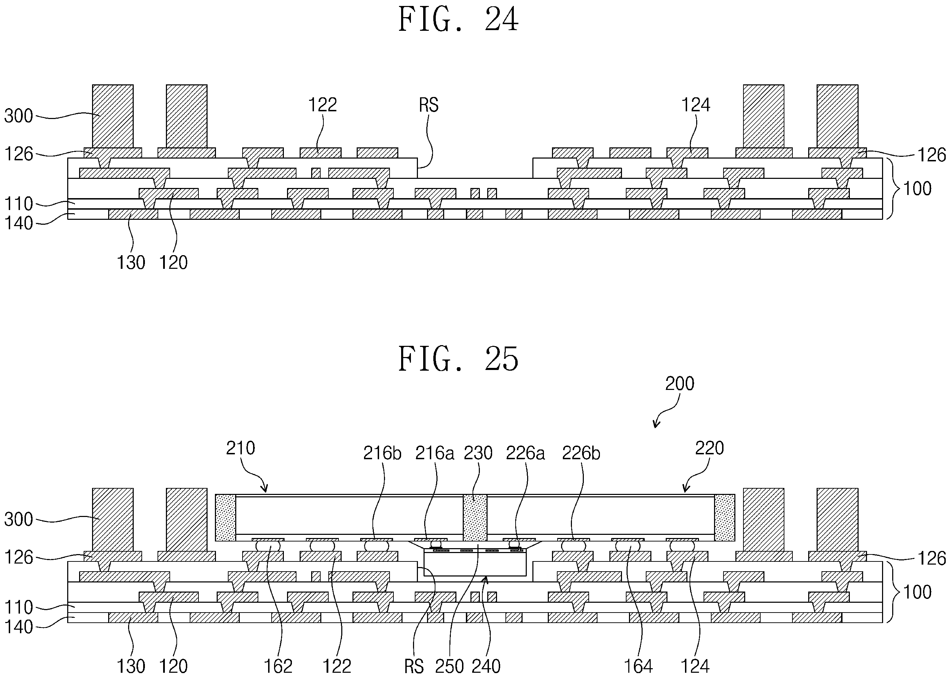

Referring to FIG. 24, the conductive posts 300 may be formed on the first redistribution substrate 100. For example, the formation of the conductive posts 300 may include forming a sacrificial layer on the first redistribution substrate 100, patterning the sacrificial layer to form holes exposing the third substrate pads 126, and filling the holes with a conductive material. Next, the sacrificial layer may be removed.

Referring to FIG. 25, the module structure 200 may be mounted on the first redistribution substrate 100. For example, the third inner terminals 162 may be provided on the second chip pads 216b of the first semiconductor chip 210, and the fourth inner terminals 164 may be provided on the fourth chip pads 226b of the second semiconductor chip 220. The module structure 200 may be disposed on the first redistribution substrate 100 in such a way that the third inner terminals 162 are aligned with the first substrate pads 122, the fourth inner terminals 164 are aligned with the second substrate pads 124, and the bridge chip 240 is inserted in the recess region RS. Next, a reflow process may be performed to bond the third inner terminals 162 to the first substrate pads 122 and the second chip pads 216b and to bond the fourth inner terminals 164 to the second substrate pads 124 and the fourth chip pads 226b.

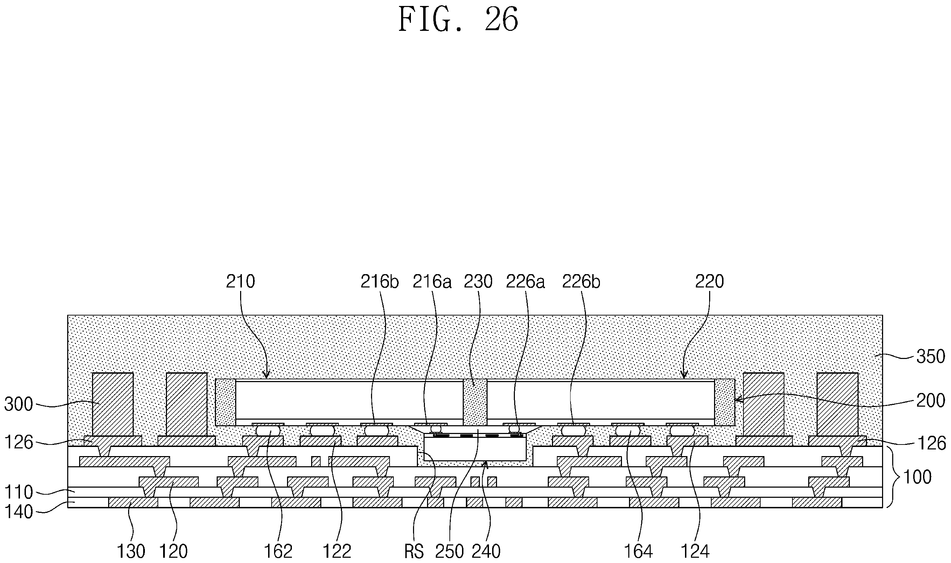

Referring to FIG. 26, the second mold layer 350 may be formed on the first redistribution substrate 100. For example, the formation of the second mold layer 350 may include coating the first redistribution substrate 100 with a molding material to cover the module structure 200 and the conductive posts 300 and curing the molding material. The molding material may be supplied into the recess region RS. For example, the molding material may be supplied into a region between the recess region RS and the bridge chip 240.

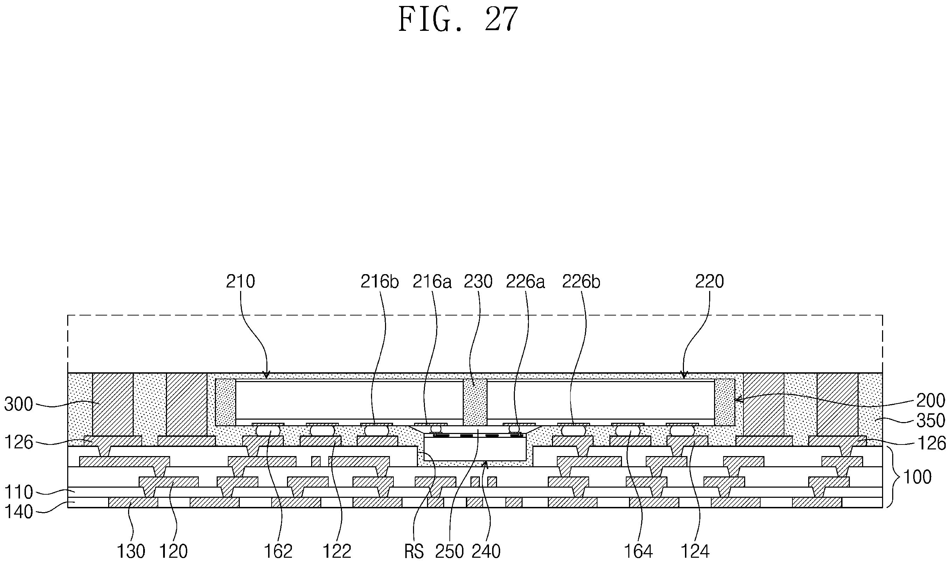

Referring to FIG. 27, a thinning process may be performed on the second mold layer 350. An upper portion of the second mold layer 350 may be removed by the thinning process. The thinning process may be performed to expose the top surfaces of the conductive posts 300.

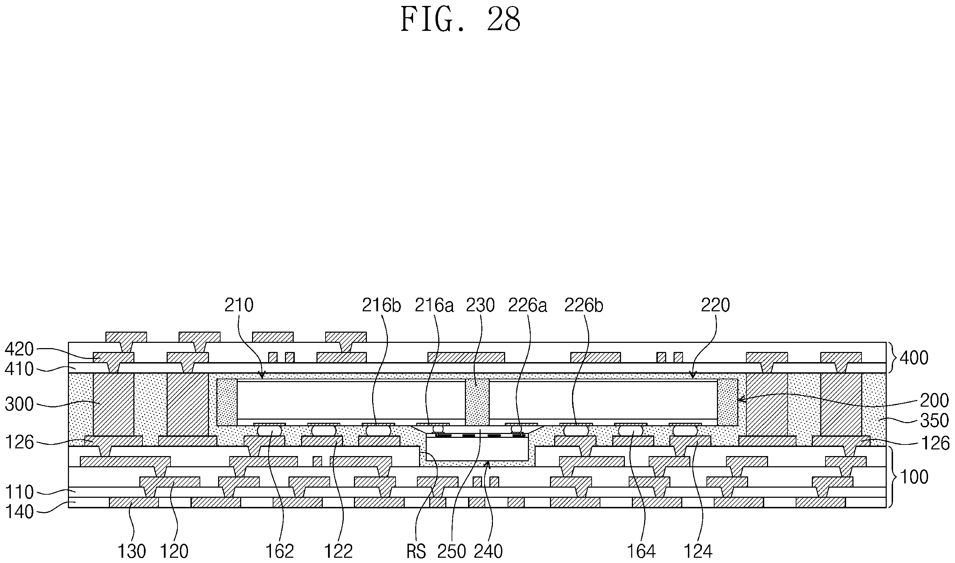

Referring to FIG. 28, the second redistribution substrate 400 may be formed on the second mold layer 350. For example, the second substrate insulating pattern 410 may be formed on the second mold layer 350. The second substrate insulating pattern 410 may be formed using a deposition process or a coating process. The second substrate interconnection pattern 420 may be formed by patterning the second substrate insulating pattern 410 to form openings exposing the conductive posts 300, forming a seed layer to conformally cover the top surface of the second substrate insulating pattern 410 and inner surfaces of the openings, performing a plating process using the seed layer as a seed to form a conductive layer coupled to the second substrate insulating pattern 410, and patterning the conductive layer.

As a result of the above process, one second substrate interconnection layer may be formed to include the second substrate insulating pattern 410, which is provided on the second mold layer 350, and the second substrate interconnection pattern 420, which is provided in the second substrate insulating pattern 410. The second redistribution substrate 400 may be formed by repeating a process of forming the second substrate interconnection layer.

Referring back to FIG. 1, the upper package 700 may be mounted on the second redistribution substrate 400. The heat-dissipation member 800 may be placed on and attached to the second redistribution substrate 400. The outer terminals 150 may be provided on the outer pads 130.

According to an embodiment of the inventive concept, first and second semiconductor chips may be directly connected to a bridge chip, and thus, it may be possible to increase an integration density of a semiconductor package. In addition, the first and second semiconductor chips and the bridge chip may be provided as a single module structure, and this may make it possible to simplify the fabrication process of the semiconductor package. The bridge chip may be inserted in a recess region of a first redistribution substrate, and thus, it may be possible to reduce the height and size of the semiconductor package. Furthermore, the first and second semiconductor chips may be protected by a first mold layer of the module structure, and thus, it may be possible to improve the structural stability of the semiconductor package.

While example embodiments of the inventive concept have been particularly shown and described, it will be understood by one of ordinary skill in the art that variations in form and detail may be made therein without departing from the spirit and scope of the attached claims.

## Claims

1. A semiconductor package, comprising:
a first redistribution substrate;
a first semiconductor chip and a second semiconductor chip, which are mounted on the first redistribution substrate and are horizontally spaced apart from each other;
a first mold layer provided to surround the first and second semiconductor chips and expose bottom surfaces of the first and second semiconductor chips;
a bridge chip mounted on the bottom surfaces of the first and second semiconductor chips;
a second mold layer provided on the first redistribution substrate to embed the first and second semiconductor chips, the first mold layer, and the bridge chip;
a second redistribution substrate disposed on the second mold layer;
an upper package mounted on the second redistribution substrate; and
a vertical connection structure provided adjacent to the first mold layer to connect the first and second redistribution substrates to each other,
wherein the first redistribution substrate has a recess provided in a top surface of the first redistribution substrate, and
wherein the bridge chip is disposed in the recess.

2. The semiconductor package of claim 1, wherein:
the bottom surfaces of the first and second semiconductor chips are active surfaces, and
a top surface of the bridge chip facing the first and second semiconductor chips is an active surface.

3. The semiconductor package of claim 1, wherein the bridge chip overlaps at least a portion of the first semiconductor chip and at least a portion of the second semiconductor chip, when viewed in a plan view.

4. The semiconductor package of claim 1, wherein:
the first semiconductor chip includes a first chip pad provided on the bottom surface of the first semiconductor chip,
the second semiconductor chip includes a second chip pad provided on the bottom surface of the second semiconductor chip, and
the bridge chip is electrically connected to the first and second chip pads.

5. The semiconductor package of claim 4, further comprising:
first inner terminals connecting the bridge chip to the first and second chip pads; and
an under-fill layer provided to fill a space between a top surface of the bridge chip and the first and second semiconductor chips and surround the first inner terminals.

6. The semiconductor package of claim 1, wherein the bridge chip is spaced apart from an inner side surface and a bottom surface of the recess, and
the second mold layer fills a space between the bridge chip and the inner side surface and bottom surface of the recess.

7. The semiconductor package of claim 1, further comprising second inner terminals, which are provided on the bottom surfaces of the first and second semiconductor chips and are horizontally spaced apart from the bridge chip,
wherein the first and second semiconductor chips are mounted on the top surface of the first redistribution substrate using the second inner terminals.

8. The semiconductor package of claim 1, wherein:
the bottom surfaces of the first and second semiconductor chips are in contact with the top surface of the first redistribution substrate,
the first redistribution substrate comprises a substrate insulating pattern and a substrate interconnection pattern in the substrate insulating pattern, and
the substrate interconnection pattern penetrates the substrate insulating pattern and is coupled to chip pads of the first and second semiconductor chips.

9. The semiconductor package of claim 1, wherein:
a depth of the recess is in a range from 1 µm to 10 µm, and
a thickness of the first redistribution substrate is in a range from 20 µm to 50 µm.

10. The semiconductor package of claim 1, wherein:
the first redistribution substrate comprises a first region and a second region, which are horizontally spaced apart from each other,
the first and second semiconductor chips are mounted on the first region of the first redistribution substrate, and
the vertical connection structure is disposed on the second region.

11. The semiconductor package of claim 10, further comprising a heat-dissipation member provided over the first region and attached to a top surface of the second redistribution substrate,
wherein the upper package is disposed on the second region.

12. The semiconductor package of claim 1, further comprising a heat-dissipation member, which is provided over the second semiconductor chip and is attached to a top surface of the second redistribution substrate,
wherein the upper package is disposed to be horizontally spaced apart from the second semiconductor chip, when viewed in a plan view.

13. The semiconductor package of claim 1, wherein:
the first and second semiconductor chips comprise a logic chip, and
the upper package comprises an upper package substrate, a memory chip mounted on the upper package substrate, and an upper mold layer provided on the upper package substrate to cover the memory chip.

14. A method of fabricating a semiconductor package, comprising:
placing a first semiconductor chip and a second semiconductor chip to be spaced apart from each other;
forming a first mold layer to surround the first and second semiconductor chips, the first mold layer exposing an active surface of the first semiconductor chip and an active surface of the second semiconductor chip;
mounting a bridge chip on the active surface of the first semiconductor chip and the active surface of the second semiconductor chip to form a module structure;
forming a recess in a top surface of a first redistribution substrate;
placing the module structure on the first redistribution substrate to insert the bridge chip in the recess;
forming a vertical connection structure on the first redistribution substrate to be horizontally spaced apart from the module structure;
forming a second mold layer on the first redistribution substrate to cover the module structure and the vertical connection structure; and
forming a second redistribution substrate on the second mold layer.

15. The method of claim 14, further comprising:
providing inner connection terminals on the active surface of the first semiconductor chip and the active surface of the second semiconductor chip, before the placing of the module structure on the first redistribution substrate; and
performing a reflow process on the inner connection terminals to mount the first and second semiconductor chips on the first redistribution substrate, after the placing of the module structure on the first redistribution substrate.
